(19) **Europäisches Patentamt**

**European Patent Office**

**Office européen des brevets**

(11) **EP 1 025 277 B1**

(12) **EUROPÄISCHE PATENTSCHRIFT**

(45) Veröffentlichungstag und Bekanntmachung des Hinweises auf die Patenterteilung:
**20.11.2002 Patentblatt 2002/47**

(51) Int Cl.[7]: **C23C 14/56**, B01J 3/03, C23C 14/50

(21) Anmeldenummer: **98943617.5**

(22) Anmeldetag: **25.09.1998**

(86) Internationale Anmeldenummer:
**PCT/CH98/00411**

(87) Internationale Veröffentlichungsnummer:
**WO 99/016927 (08.04.1999 Gazette 1999/14)**

(54) **VAKUUMBESCHICHTUNGSANLAGE UND KOPPLUNGSANORDNUNG UND HERSTELLUNGSVERFAHREN FÜR WERKSTÜCKE**

VACUUM COATING INSTALLATION AND COUPLING DEVICE AND PROCESS FOR PRODUCING WORK PIECES

INSTALLATION DE METALLISATION SOUS VIDE ET DISPOSITIF D'ACCOUPLEMENT ET PROCEDE POUR PRODUIRE DES PIECES D'OEUVRE

(84) Benannte Vertragsstaaten:
**CH DE ES FR GB IT LI SE**

(30) Priorität: **29.09.1997 CH 227897**
**25.08.1998 CH 173698**

(43) Veröffentlichungstag der Anmeldung:
**09.08.2000 Patentblatt 2000/32**

(73) Patentinhaber: **Unaxis Trading AG**
**9477 Trübbach (CH)**

(72) Erfinder:
• **HANS, Michael**
**A-6700 Bludenz (AT)**
• **ZAECH, Martin**
**FL-9496 Balzers (LI)**

(74) Vertreter: **Troesch Scheidegger Werner AG**
**Patentanwälte**
**Postfach**
**8032 Zürich (CH)**

(56) Entgegenhaltungen:
**DE-A- 3 338 580          GB-A- 2 114 160**

• **PATENT ABSTRACTS OF JAPAN vol. 012, no. 283 (C-518), 3. August 1988 & JP 63 062875 A (KOBE STEEL LTD), 19. März 1988**
• **PATENT ABSTRACTS OF JAPAN vol. 097, no. 008, 29. August 1997 & JP 09 104986 A (ANELVA CORP), 22. April 1997**

**Beschreibung**

Die vorliegende Erfindung betrifft eine Vakuumbeschichtungsanlage nach dem Oberbegriff von Anspruch 1 eine Kopplungsanordnung nach dem Oberbegriff von Anspruch 27 sowie ein Herstellungsverfahren nach demjenigen von Anspruch 29.

Anlagen erstgenannter Art, bei welchen von einer zentralen Verteilkammer darum herum gruppierte Behandlungskammern mittels einer in der Verteilkammer angeordneten Transportanordnung bzw. eines Transportroboters bedient werden und die Verteilkammer von aussen über eine Bedienungskammer, z.B. über eine Ein- und Austrittsschleusenkammer oder eine Eintritts- und eine Austrittsschleusenkammer, bedient wird, sind hinlänglich bekannt. Mittels solcher Anlagen werden Werkstücke, wie z.B. Speicherscheiben, Halbleiterwafer einzeln behandelt. Das Behandlungsgut wird hier durch einzelne Werkstücke gebildet.

So ist es beispielsweise aus Patent Abstract of Japan Vol. 097 No. 008, 29 of August 1997 and JP-A 09104986 eine derartige Anlage bekannt. Dabei handelt es sich um eine Mehrkammer-CVD-Anlage mit einer zentralen Vakuumverteilkammer, darin einem Transportroboter zum Verteilen der Werkstücke an die Vakuumkammern sowie mit einer "load-lock"-Schleuse. Dabei sind alle Kammern getrennt verschliessbar.

Diese Anlagen ermöglichen einerseits, eine erwünschte prozesstechnische Trennung zwischen den Behandlungskammern bzw. zwischen Verteilkammer und Behandlungskammern bzw. Bedienungskammer, wie dies für die hochdiffizilen Behandlungen an den erwähnten Werkstücken erforderlich ist, relativ einfach zu realisieren. Dabei ist es für derartige Anlagen weiter typisch, dass die Werkstücke im wesentlichen plan und flächig sind und üblicherweise nur einseitig zu behandeln, wie beispielsweise zu beschichten sind.

Mit diesen bekannten Anlagen lassen sich hochdiffizile, komplexe Schichtsysteme realisieren, was ununterbrochen in Vakuumatmosphäre erfolgt und teilweise, wie erwähnt, unter prozesstechnischer Abtrennung der einzelnen Behandlungsschritte.

Aufgrund der hohen Werkstückkosten und der hohen Prozesskosten wird bei den erwähnten Anlagen ein relativ geringer Durchsatz in Kauf genommen, bedingt durch die Einzelwerkstückhandhabung.

Für die Behandlung von Werkstücken, welche mit Bezug auf Behandlungs-Qualität, z.B. bei deren Beschichtung, weit weniger kritisch sind, als die oben erwähnten, so beispielsweise und insbesondere für das Aufbringen von Verschleisschutz-Schichtsystemen an Werkzeugen, wie für die spanabhebende Bearbeitung oder an Maschinenbauelemente, wird der Häufigkeit auftretender Fehlerstellen, z.B. in der Beschichtung, weniger Beachtung geschenkt: Es wird einem hohen Durchsatz Priorität gegeben. Deshalb ist es üblich, solche Werkstücke in Vakuumbeschichtungsanlagen zu behandeln, in welche eine Vielzahl solcher Werkstücke als Batch eingeführt und jeweils einem Behandlungsschritt unterworfen wird. Sind mehrere Vakuumbehandlungsschritte notwendig, so wird der Batch oft als Ganzes von einer Anlage weiteren Anlagen zugeführt, dazwischen der Umgebungsatmosphäre ausgesetzt.

Ausserdem müssen die Werkstücke der hier angesprochenen Art, also z.B. Werkzeugkörper mit hochkomplizierter Form, z.B. mit Spiral-Schneidekanten, Frässchneiden etc. dreidimensional behandelt werden und dies gerade und insbesondere auch dort, wo die Körperform am komplexesten ist. Dies erfordert besondere zusätzliche Massnahmen, wie z.B. spezielle Bewegungen der Werkstückkörper im jeweiligen Behandlungsprozess. Bei grossen Batch-Einheiten kompliziert dies die Anordnung wesentlich.

Mittels solcher Anlagen sind deshalb die Gesamtherstellungskosten für die zu behandelnden Werkstücke nur schwierig wesentlich weiter zu senken.

Bei den Werkstücken letztgenannter Art besteht auch die Tendenz, die Qualitätsansprüche an die Behandlung in vielen Fällen zu erhöhen. Beispielsweise ergibt sich aus erhöhten Anforderungen betreffs Arbeitsleistung für spanabhebende Werkzeuge oder an die Beanspruchbarkeit von Maschinenbauelementen fallweise auch eine erhöhte Qualitätsanforderung bezüglich ihrer Behandlung. Es ist ohne weiteres ersichtlich, dass das gleichzeitige Erfüllen ggf. erhöhter Qualitätsanforderungen an die Behandlung und der primären Durchsatzanforderungen eine Herausforderung für die Entwicklung darstellt.

Die vorliegende Erfindung setzt sich unter einem ersten Aspekt zum Ziel, eine Anlage bzw. ein Verfahren eingangs genannter Art vorzuschlagen, bei der, unter Beibehaltung der Vorteile von Einzelwerkstück-Behandlungsanlagen obgenannter Art, die hohen Durchsätze von Batch-Behandlungsanlagen erzielt werden und-falls gefordert - auch die Vorteile bezüglich Behandlungsqualität der Einzelwerkstückanlagen kostengünstig realisierbar sind. Es soll eine Anlage geschaffen werden, die hohe Durchsätze zulässt, in Konstruktion und Betrieb kostengüstig ist und bei der die Behandlung gut reproduzierbar ist. Dabei sollen im obgenannten Sinn hochkomplex geformte Werkstückkörper dreidimensional behandelt und insbesondere beschichtet werden können.

Diese Aufgabe wird durch eine Vakuumbehandlungsanlage erstgenannter Art gelöst, welche sich nach dem Kennzeichen von Anspruch 1 auszeichnet bzw. durch das Verfahren nach dem Kennzeichen von Anspruch 29. Mithin werden nicht mehr einzelne sondern eine Vielzahl von Werkstücken, jeweils an einem Werkstückträger eingesetzt, je mit einer Vielzahl von Werkstückaufnahmen. Zusätzlich wird die geforderte dreidimensionale Behandlung mindestens beim Beschichten dadurch realisiert, dass in mindestens einer der vorgesehenen Behandlungskammern die Werkstücke in bzw. mit ihren Aufnahmen bewegt werden.

Im weiteren werden im Sinne obengenannter Aufgabe der Durchsatz und die dreidimensionale Werkstückbehandlung durch Vorsehen der Kopplungsanordnung nach Anspruch 27 verbessert.

Damit werden nun bekannte Ein-Prozess-Batchanlagen erfindungsgemäss zu Behandlungskammern an der erfindungsgemässen Anlage, wobei der Transport von einer Batchanlage zur anderen nicht mehr über die Umgebungsatmosphäre erfolgt, sondern erfindungsgemäss über die evakuierbare Verteilkammer: Die gesamte Behandlung erfolgt unter Vakuum. Damit ist es auch möglich, die einzelnen Behandlungskammern prozesstechnisch voneinander in jeweils erforderlichem Umfang zu trennen bzw. die Behandlungskammern von der Verteilkammer und damit erforderlichenfalls hohe Qualitätsansprüche zu erfüllen.

Primär wird aber der Durchsatz bezüglich der vorerwähnten Batchanlagen nicht nur beibehalten, sondern gar erhöht.

Die erfindungsgemässe Anlage weist weiter praktisch immer mindestens eine Beschichtungskammer auf.

Obwohl diese als Niederdruck-CVD-Behandlungskammer ausgebildet sein kann, wird insbesondere mit Blick auf die kostengünstige Applikation von Verschleissschutz-Schichtsystemen vorgeschlagen, dass sie mindestens eine Plasmaentladungsstrecke aufweist sowie mindestens einen Einlass, der mit einer Gasvorratseinrichtung mit einem reaktiven Gas verbunden ist. Mit anderen Worten ist vorzugsweise mindestens eine der Kammern als PVD-Behandlungskammer oder als PECVD-Behandlungskammer ausgebildet.

Dabei können, für den gleichzeitigen Aufbau komplexerer Schichten oder für das Behandeln der Werkstücke mittels zweier und mehr Prozesse hintereinander, durchaus in einer Behandlungskammer mehrere Plasmaentladungsstrecken vorgesehen sein und, entsprechend, ggf. mehrere Reaktivgaseinlässe, sofern sich die jeweils sequentiell durchzuführenden Behandlungsprozesse - wie z.B. Sputtern und Ätzen - nicht stören.

Für das Ablegen von Verschleissschutz-Schichtsystemen wird in der Gasvorratseinrichtung bevorzugterweise Stickstoff und/oder Wasserstoff und/oder ein kohlenstoffhaltiges Gas und/oder ein siliziumhaltiges Gas vorgesehen.

Ist die Behandlungskammer als PVD-Behandlungskammer ausgebildet, so weist sie mindestens eine Dampfteilchen in die Umgebung freisetzende Quelle auf. Die Dampfteilchen werden z.B. durch Sputtern von einem Festkörpertarget oder durch thermisches Verdampfen aus einer Schmelze oder durch eine Mischform dieser Techniken, wie durch kathodisches Arc-Verdampfen, freigesetzt. Das freigesetzte Material ist bevorzugterweise ein Metall oder eine Metallegierung, dabei vorzugsweise Ti, W, Al und/oder Cr oder Silizium enthaltend, oder aber ein Oxid, Nitrid, Oxinitrid, Karbid, Oxikarbid, Oxikarbonitrid eines der erwähnten Metalle/Legierungen. Die erwähnten Metallverbindungen werden reaktiv oder nichtreaktiv abgelegt. Für das Freisetzen der Beschichtungsfeststoffkomponenten werden bevorzugterweise folgende Quellen eingesetzt:

- Verdampfungsquellen, welche thermisches Verdampfen einsetzen, wie beispielsweise anodische Bogenverdampfungsquellen oder Elektronenstrahl-Verdampfungsquellen,

- kathodische Bogenverdampfungsquellen,

- Sputterquellen, dabei vorzugsweise Magnetronquellen.

Insbesondere für das Ablegen von Verschleissschutzschichtsystemen wird weiter vorgeschlagen, dass eine weitere der mindestens zwei vorgesehenen Behandlungskammern eine Heizkammer ist und/oder eine Ätzkammer.

Sofern an ein und derselben Behandlungskammer mehr als ein Behandlungsschritt durchgeführt werden kann, z.B. sowohl Heizen wie auch Ätzen, wird bevorzugterweise eine Zeitsteuereinheit mit der Kammer wirkverbunden, welche Einheit die Abfolge der Schritte und deren Prozess-Parameter steuert. Dadurch wird die Anzahl notwendiger Transportschritte verringert, bzw. es werden Behandlungskammern eingespart.

An der erfindungsgemässen Vakuumbehandlungsanlage ist vorzugsweise eine Zeitsteuereinheit vorgesehen, welche einerseits mit einem Antrieb für die Behandlungsgut-Transportanordnung in der Verteilkammer, anderseits mit dem Antrieb und/oder der Antriebsverbindung an mindestens einer Behandlungskammer wirkverbunden ist und die die zeitliche Abfolge von Transportzyklen und Behandlungszyklen sowie der Bedienungszyklen steuert.

In einer weiteren bevorzugten Ausführungsform wird vorgeschlagen, dass an der Behandlungsgut-Transportanordnung eine mit den Öffnungen dichtend wirkverbindbare Dichtanordnung vorgesehen ist, welche ggf. unabhängig von Behandlungsgut-Transportanordnungs-Hubbewegung ansteuerbar ist. Damit wird die Möglichkeit geschaffen, ggf. selektiv, beispielsweise schleusenventilähnlich, die Öffnung zwischen Bedienungskammer und Verteilkammer und/oder die Öffnung zwischen einer Behandlungskammer und der Verteilkammer prozesstechnisch zu schliessen, sei dies durch Erstellen einer Druckstufe, wie mittels eines Dichtungsspaltes, sei dies durch Erstellung einer vollständigen Vakuumtrennung durch sich gegenseitig berührende Teile der Dichtungsanordnung an der Transportanordnung und an der angesprochenen Öffnung.

Dabei ist es durchaus möglich, ggf. gewisse der Öffnungen während des Betriebs der zugeordneten Kammer gegenüber der Verteilkammer nicht prozesstechnisch zu schliessen, wie beispielsweise eine Verbindungsöffnung zwischen Heizkammer und Verteilkammer, insbesondere dann, wenn die weiteren Behandlungskammern separat abpumpbar sind und bei deren Betrieb die jeweiligen Öffnungen prozesstechnisch verschlossen werden.

Das prozesstechnische Abtrennen der Kammern wird dadurch besonders einfach, dass dem Werkstückträger bzw. den Werkstückträgern für Werkstücke, die eine solche Abtrennung erfordern, Dichtungsorgane fest zugeordnet werden, die sich, mit dem Träger eine Einheit bildend, durch die Anlage bewegen.

Wie eingangs erwähnt wurde, ist es sehr oft wesentlich, dreidimensional hochkomplex geformte Werkstückkörper auch lückenlos dreidimensional zu behandeln, insbesondere zu beschichten. Dies wird dadurch erreicht, dass zwischen den Werkstücken und insbesondere gerichteten Quellen, z.B. an einer Behandlungskammer für Ätzen oder Sputterbeschichten, eine Relativbewegung erstellt wird. Hierzu wird vorgeschlagen, eine Antriebsverbindung vorzusehen, welche letztendlich auf die Werkstückaufnahmen wirkt, zwischen einem Antrieb und einem jeweiligen Werkstückträger. Wird zwischen kammerseitiger, stationärer Quelle und dem Werkstückträger eine Relativbewegung erstellt, insbesondere bevorzugt eine Rotationsbewegung, so wird dadurch eine oft bereits ausreichende dreidimensionale Behandlung sichergestellt. In einer bevorzugten Ausführungsform wird aber die erwähnte Antriebsverbindung zusätzlich auf beweglich am Werkstückträger gelagerte Werkstückaufnahmen erstellt, womit, wie insbesondere mittels einer Planetenübertragung, einerseits der Werkstückträger und, daran, anderseits die Werkstückaufnahmen insbesondere in Drehbewegung versetzt werden.

Für die gesamte Anlage wird weiter bevorzugterweise eine zentrale Steuereinheit vorgesehen, vorzugsweise frei programmierbar, d.h. mit wahlweise abrufbaren, frei programmierten und abgespeicherten Sequenzen. Diese Steuereinheit taktet einerseits den Betrieb der Transportanordnung, anderseits den Antrieb und/oder die Antriebsverbindung an der mindestens einen Behandlungskammer sowie den Betrieb von Ventilen, so z.B. von Schleusenventilen an der Bedienungskammer zur Verteilkammer, und zudem den Prozessbetrieb der Kammern.

Beim Transport von Werkstückträgern der eingangs genannten Art von einer Kammer zur andern ist es notwendig, zwischen den jeweiligen Kammern und dem jeweiligen Werkstückträger eine Kopplung zu erstellen, sei dies eine elektrische, beispielsweise zur Biaslegung der Werkstücke, oder eine mechanische, letztlich zum Rotationsantrieb der Werkstücke. Auch andere Kopplungen können erwünscht sein, wie für ein Kühlmedium, das in die Werkstückträger eingeführt wird. Um eine solche Kopplung zu realisieren, wird an der Anlage erstgenannter Art an mindestens einer der Behandlungskammern ein Behandlungskammer-Kegelstumpfrad vorgesehen sowie an den Werkstückträgern ein vorragendes Werkstückträger-Kegelstumpfrad, wobei die Stirnflächen - vorzugsweise dabei mindestens eine der kleineren Stirnflächen - einerseits des Behandlungskammer-Kegelstumpfrades und jeweils eines Werkstückträger-Kegelstumpfrades aufeinander anliegen, wenn der Werkstückträger in der Behandlungskammer in Bearbeitungsposition ist. Dabei wird bevorzugterweise mindestens eines der Kegelstumpfräder axial federnd gelagert, womit, wenn der Werkstückträger mit seinem Rad, bevorzugterweise in einer ebenen, insbesondere linearen Bewegung, in die Kammer eingeführt wird, sich die Kegelstumpfräder erst entlang ihren Mantelflächen berühren und, aufgrund der Keilwirkung der sich stossenden Kegelmantelflächen, gegen die Federkraft gespannt wie erwähnt aufeinander zu liegen kommen.

Nun kann in einer bevorzugten Ausführungsform das werkstückseitige Kegelstumpfrad mit Werkstückaufnahmen am Werkstückträger-Drehantrieb gekoppelt sein, und es ist dann ein motorischer Drehantrieb kammerseitig vorgesehen, der, in Behandlungsposition des Werkstückträgers, mit dem werkstückträgerseitigen Kegelstumpfrad gekoppelt ist.

Der kammerseitige Drehantrieb, letztendlich für die Werkstückaufnahmen am Werkstückträger, wirkt bevorzugterweise über das kammerseitige Kegelstumpfrad auf das werkstückträgerseitige Kegelstumpfrad, oder wirkt über einen vom kammerseitigen Kegelstumprad unabhängig wirkenden Antrieb auf das werkstückträgerseitige Kegelstumpfrad.

In einer weiteren bevorzugten Ausführungsform der erfindungsgemässen Anlage - bei der die erwähnten Räder nicht oder nicht nur der Antriebsübertragung dienen - ist sowohl das kammerseitige Kegelstumpfrad wie auch das werkstückträgerseitige mindestens an Kegelstumpf-Stirnflächen elektrisch leitend ausgebildet - dabei mindestens an einem der kleineren Stirnflächen -, und es ist die elektrisch leitende Fläche des werkstückträgerseitigen Kegelstumpfrades elektrisch leitend mit Werkstückaufnahmen verbunden, wogegen die elektrisch leitende, kleine Stirnfläche des kammerseitigen Kegelstumpfrades mit einer vorzugsweise einstellbaren elektrischen Quelle verbunden ist. Damit wird ermöglicht, mit den vorgesehenen Kegelstumpfrädern eine mechanische Antriebskopplung und/oder eine elektrische Verbindungskopplung zwischen jeweiligen Kammern und Werkstucckträgern zu erstellen.

Obwohl, wie erwähnt, die eben erwähnte Kopplung eine bevorzugte Ausführungsform der eingangs erwähnten Anlage bildet, wird vorgschlagen, die elektrische und/oder mechanische Kopplungsanordnung grundsätzlich zwischen einer Vakuumbehandlungskammer und einem Werkstückträger mit in der Kammer zu behandelnden Werkstücken, d.h. auch für Einkammeranlagen einzusetzen, indem wie erwähnt wurde gemäss Anspruch 27 ein kammerseitiges Kegelstumpfrad und ein werkstückträgerseitiges Kegelstumpfrad vorgesehen sind, deren Stirnflächen - dabei vorzugsweise mindestens eine der kleineren Stirnflächen umfassend - in Behandlungsposition des Werkstückträgers in der Kammer aufeinander anliegen und somit eine mechanische Antriebsverbindung und/oder eine elektrische Übertragungsverbindung von Kammer auf Werkstückträger erstellen.

Im weiteren wird in einer bevorzugten Ausführungsform der eingangs erstgenannten Behandlungsanlage, an der Behandlungsgut-Transportanordnung in der Verteilkammer für jeweils einzelne Werkstückträger, je ein Scherenmechanismus vorgesehen, mit einem Paar Hebelanordnungen, welche so relativ zueinander zentral schwenkbar gelagert sind, dass die Hebelarme vom Schwenklager zu den jeweiligen Hebelendlagern gleich lang sind. In einer weiter bevorzugten Ausführungsform ist dabei mindestens eines der endständigen Hebelschwenklager des Scherenmechanismus linear verschieblich an einem in der Verteilkammer zentral vorgesehenen Zentralteil der Transportanordnung gelagert, wobei der Scherenmechanik-Antrieb ein Linearantrieb für das mindestens eine linear beweglich gelagerte Endlager des Scherenmechanismus umfasst oder einen nicht linearen Antrieb, der vorzugsweise über eine Nockenscheibe mit Übertragungshebel auf einen der Scherenmechanismushebel wirkt.

Wenn an den eingangs erstgenannten Behandlungsanlagen Kammern prozesstechnisch zu trennen sind, zwischen welchen relativ grosse Druckdifferenzen, vorzugsweise ab 4 mbar, vorherrschen, so wird bevorzugt die prozesstechnische Abtrennung mit der vorerwähnten Dichtplatte zusätzlich durch eine unabhängig von der Transportanordnung betätigbare Spannvorrichtung gesichert. Bevorzugterweise weist diese eine motorisch verschiebliche Rollenanordnung auf, kammerseitig oder dichtplattenseitig, sowie eine Kurvenplatte, entsprechend dichtplattenseitig oder kammerseitig, wobei die Rollenanordnung mit der Kurvenbahn der Kurvenplatte, zur Erstellung oder Lösung der Dichtungspressung zwischen Dichtplatte und Öffnungsberandung, in Wirkverbindung steht.

Obwohl diese eben erwähnte, zusätzliche Dichtungssicherung bevorzugt auch an der eingangs erwähnten, erstgenannten Anlage eingesetzt wird, kann sie selbstverständlich auch bei Anlagen eingesetzt werden, bei denen beispielsweise nur eine Behandlungskammer vorgesehen ist, wie beispielsweise bei Schleusenkammern.

Die Erfindung wird anschliessend beispielsweise anhand von Figuren erläutert. Es zeigen:

Fig. 1: schematisch eine erste Ausführungsform eines an einer erfindungsgemässen Anlage eingesetzten Werkstückträgers;

Fig. 2: in Darstellung analog zu Fig. 1, einen zweiten Typ eines an einer erfindungsgemässen Anlage bevorzugt eingesetzten Werkstückträgers;

Fig. 3: schematisch im Längsschnitt, eine erste Ausführungsform einer erfindungsgemässen Anlage;

Fig. 4: eine Querschnittsdarstellung gemäss Linie IV-IV durch die Anlage gemäss Fig. 3;

Fig. 5: in Darstellung analog zu Fig. 3, schematisch den Aufbau einer weiteren Ausführungsform einer erfindungsgemässen Anlage;

Fig. 6: analog zu Fig. 4, eine Schnittdarstellung gemäss VI-VI durch die Anlage gemäss Fig. 5;

Fig. 7: einen Teillängsschnitt durch eine weitere Ausführungsform einer erfindungsgemässen Anlage mit in eine Behandlungskammer eingeführtem Werkstückträger;

Fig. 8 : in Darstellung gemäss Fig. 7 die Anlage mit in die Verteilkammer rückgeholtem Werkstückträger;

Fig. 9: eine geschnittene Aufsicht auf eine Vierkammeranlage, aufgebaut nach dem anhand der Figuren 7 und 8 dargelegten Prinzip;

Fig. 10: in Darstellung analog zu Fig. 9 eine erfindungsgemässe Fünfkammeranlage;

Fig. 11: im Längsschnitt schematisch eine weitere erfindungsgemässe Anlage;

Fig. 12: Die Darstellung der Anlage nach Fig. 11 im Querschnitt gemäss Linie XI-XI;

Fig. 13: den Längsschnitt durch eine weitere Ausführungsform einer erfindungsgemässen Anlage, im wesentlichen aufgebaut wie die Anlage gemäss den Figuren 7 bis 10;

Fig. 14: in perspektivischer Ansicht und teilweise vereinfacht eine weitere bevorzugte Ausführungsform eines erfindungsgemäss eingesetzten Werkstückträgers;

Fig. 15: schematisch vereinfachend, eine bevorzugte Kopplungseinrichtung für mechanische und/oder elektrische Signale zwischen einer Behandlungskammer und darin zur Behandlung eingeführter Werkstückträger;

Fig. 16: in einer Darstellung analog zu Fig. 7, eine bevorzugte Ausführungsform einer erfindungsgemässen Anlage mit Scherenmechanismus-Transportantrieb für Werkstückträger, teilweise vereinfacht und schematisiert dargestellt;

Fig. 17: teilweise geschnitten, in Aufsicht, die in Fig. 16 gezeigte Anlage;

Fig. 18: anhand einer Prinzipskizze eine weitere bevorzugte Ausführungsform eines Scherenmechanismus-Antriebes für Werkstückträger in der Verteilkammer;

Fig. 19: ausgehend von den Erläuterung zu Fig. 18, weiterhin vereinfacht und teilweise schematisiert, in Darstellung analog zu Fig. 7, eine erfindungsgemässe Anlage mit Scherenmechanismus-Antrieb gemäss Fig. 18;

Fig. 20: in Darstellung analog zu Fig. 17, die teilweise geschnittene Aufsicht auf eine Anlage, aufgebaut, wie die anhand von Fig. 19 erläuterte, und

Fig. 21: anhand eines Ausschnittes zweier über eine Öffnung gekoppelter Vakuumanlagenkammern, die Realisation eines Spannmechanismus zur Sicherstellung vorgegebener Dichtungspressung einer im Prozess an die Öffnung gelegten Dichtungsplatte.

An der erfindungsgemässen Anlage werden unter einem Aspekt der Erfindung die zu behandelnden Werkstücke an einem Werkstückträger behandelt, der, um eine dreidimensionale Einwirkung der Behandlung auf die Werkstücke zu ermöglichen, in mindestens einer der vorgesehenen Behandlungskammern bewegt wird, bevorzugterweise in Rotation versetzt wird.

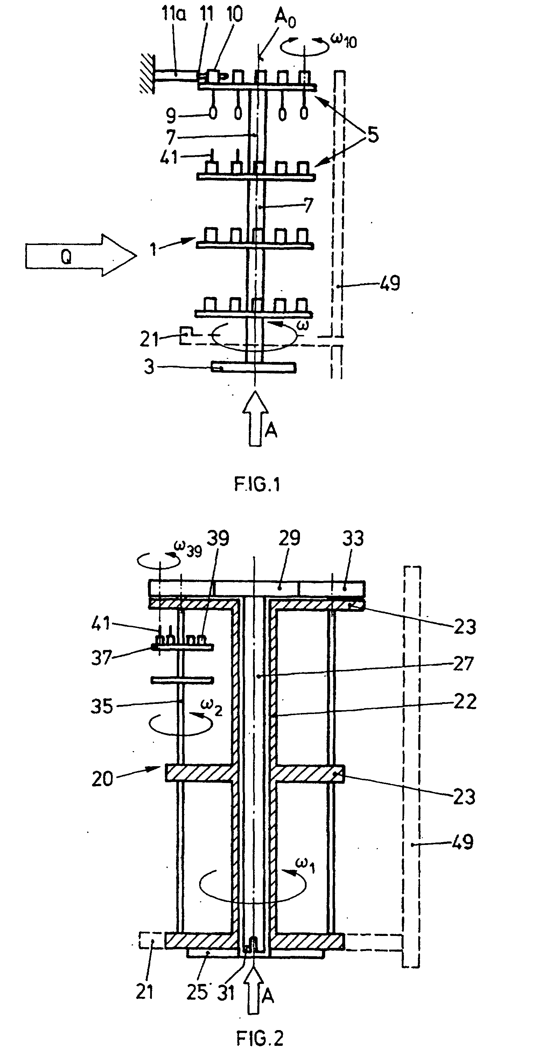

In Fig. 1 ist der prinzipielle Aufbau eines ersten erfindungsgemäss eingesetzten Werkstückträgers, beispielsweise für die Behandlung von Schaftwerkzeugen, dargestellt. Ein zylindrischer Werkstückträger 1 weist eine Drehkopplungsanordnung, beispielsweise in Form eines Reib- oder Zahnrades 3, auf. Es sind mehrere Trägerteller 5 entlang einer Zentralachse 7 angeordnet, woran Werkstücke 9 in Aufnahmehülsen 10 gelagert sind. Durch die mit dem Pfeil A schematisch dargestellte Antriebsübertragung wird an der jeweils erforderlichen Behandlungskammer der Werkstückträger 1 in Drehbewegung versetzt, so dass eine schematisch mit Q dargestellte, gerichtete Behandlungseinwirkung sich wie gefordert dreidimensional auf die Werkstücke auswirkt.

Bei der in Fig. 1 dargestellten, einfachen Ausführungsform sind die Aufnahmehülsen 10 fix an den Trägertellern 5 montiert und drehen mithin mit letzteren um die Achse A. In einer weiteren Ausführungsform werden die Hülsen 10, und mithin die darin aufgenommenen Werkstücke, wie mit $\omega_{10}$ dargestellt, auch in sich selbst in Rotation versetzt. Dies wird in höchst einfacher Art und Weise dadurch realisiert, dass einerseits die Hülsen 10 an den Tellern 5 drehgelagert werden und, wie bei 11 dargestellt, beispielsweise auskragende Mitnehmer aufweisen. Bezüglich des Werkstückträgers 1 stationär angeordnet ragt ein Anschlag 11a in die Bewegungsbahn der Mitnehmer 11 an den Hülsen 10 ein, derart, dass jedesmal, wenn eine Hülse 10 am Anschlag 11a vorbeiläuft, diese Hülse 10 um ein Drehwinkelelement in Richtung $\omega_{10}$ weitergedreht wird. Je nachdem, wieviele Anschläge 11a entlang der Bewegungsbahn der Hülsen 10 angeordnet sind, erfolgt während einer Tellerumdrehung eine ein- oder mehrmalige Weiterinkrementierung des Drehwinkels der Hülsen 10.

In einer weiteren bevorzugten Ausführungsform des erfindungsgemäss eingesetzten Werkstückträgers werden die Werkstücke bzw. die Aufnahmen hierfür auf andere Weise bezüglich des Werkstückträgers bewegt, was beispielsweise mittels einer Planetenantriebsübertragung erfolgt. Beispielsweise ist eine solche Ausbildung in Fig. 2 dargestellt. Sie umfasst eine Hohlachse 22 mit Abstütztellern 23. An der Anordnung 22/23 ist ein Antriebskopplungsrad, beispielsweise ein Reib- oder Zahnrad, 25 befestigt. In der Hohlachse 22 verläuft eine Antriebsachse 27 mit endständigem Zahnrad 29. Dem Zahnrad 29 entgegengesetzt, ist an der Antriebsachse 27 eine weitere Antriebsübertragung 31 vorgesehen, mittels welcher die Antriebsachse 27 mit dem Zahnrad 29 bezüglich der jeweiligen Behandlungskammer z.B. stationär gehalten wird. Mit dem Zahnrad 29 stehen Planetzahnräder 33 in Eingriff, die Antriebsanker 35 antreiben. An letzteren sind Trägerteller 37 befestigt, woran in Aufnahmehülsen 39 die Werkstücke 41 eingelegt sind.

Durch Antrieb über Reib- oder Zahnrad 25 wird der Werkstückträger 20 in Rotationsbewegung $\omega 1$ versetzt, gleichzeitig, über die Planetenantriebsverbindung 29/33, werden die Trägerteller 37 mit den daran vorgesehenen Werkstückaufnahmen in Form von Aufnahmehülsen 39 in Rotation versetzt.

In einer Weiterausbildung der eben anhand von Fig. 2 erläuterten Werkstückträgertechnik, können nun auch hier zusätzlich, und wie mit $\omega_{39}$ angedeutet, die einzelnen Aufnahmehülsen 39 mit einer Technik, wie sie anhand von Fig. 1 erläutert wurde, auch noch in Umdrehung versetzt werden.

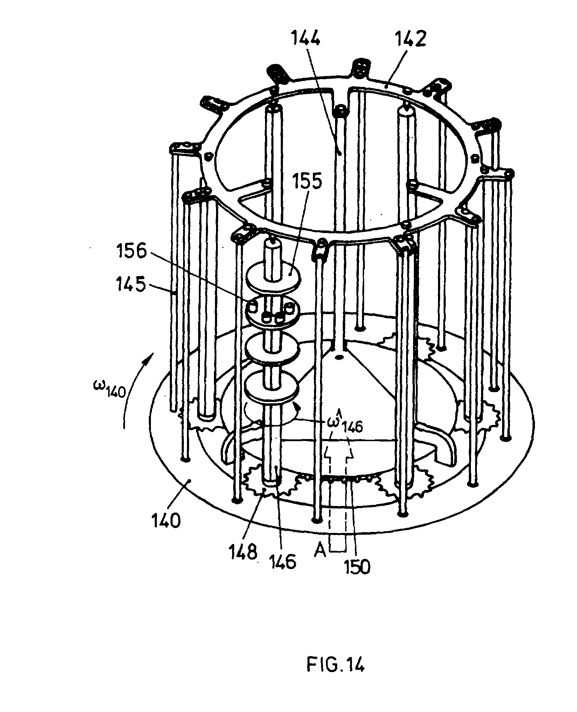

In Fig. 14 wird perspektivisch eine weitere, bevorzugte Ausführungsform des erfindungsgemäss eingesetzten Werkstückträgers dargestellt. Durch eine kreisringförmige Grundplatte 140, eine ebenso kreisringförmige Abschlussplatte 142 wird mittels Längsankern 144 ein Karusellkäfig gebildet. Dieser Karusellkäfig wird in der jeweiligen Behandlungskammer in Drehung versetzt, wie in Fig. 14 mit $\omega_{140}$ dargestellt. Parallel zu den Ankern 144 sind Drehanker 146 vorgesehen und an beiden Käfigringplatten 140 und 142 drehbeweglich gelagert. Mittels Zahnrädern 148 greifen diese Drehanker 146 auf einen zentralen, stationären Zahnkranz 150 ein, so dass sie, während der Käfig mit $\omega_{140}$ umläuft, selber mit $\omega_{146}$ umlaufen. An den Drehankern 146 sind in Analogie zu Fig. 1 Drehteller 155 angeordnet mit an den Tellern 155 selbst drehgelagerten und drehgetriebenen Aufnahmehülsen 156. Die Anschläge 11a - schematisch dargestellt - gemäss Fig. 1 werden durch Stangen 145 gebildet oder daran gehalten und ragen von dort in die Umlaufbahnen der Hülsen an den Teller 155 ein.

In den Fig. 1, 2 und 14 sind, wie erwähnt wurde, grundsätzlich Werkstückträger dargestellt, wie sie sowohl an Einkammeranlagen wie auch erfindungsgemäss an Mehrkammeranlagen der nachfolgend beschriebenen Art eingesetzt werden können.

Bezeichnet man, wie im Fachjargon üblich, die Struktur mit einer Zentralachse 7 bzw. Antriebsachse 7 bzw. 35, daran auskragenden Trägertellern 5 bzw. 37 als Werkstückträger-"Baum", so können die erwähnten Werkstückträger einen (Fig. 1) oder mehrere Werkstückbäume (Fig. 2, 14) aufweisen. Realisiert wird dabei eine grossräumige Rotationsbewegung, entsprechend $\omega_{140}$ oder $\omega_1$ der Bäumchen um eine Achse des Werkstückträgers und/oder eine Rotationsbewegung der Bäumchen um ihre Eigenachse, entsprechend $\omega$ bzw. $\omega_2$ der Fig. 1, 2 bzw. $\omega_{146}$ gemäss Fig. 14 und/oder eine noch kleinräumigere Rotationsbewegung der Werkstücke um sich selber, wie $\omega_{10}$ von Fig. 1 und $\omega_{39}$ von Fig. 2 zeigen.

Allen Ausführungsvarianten gemein ist, dass, wie bei A in den Figuren 1, 2 und 14 eingetragen, eine Drehantriebsübertragung auf die Werkstückträger erfolgen muss. Im Folgenden werden, als Einheit mittels einer Antriebsübertragung von der stationären Kammer drehgetriebene Werkstückträger, seien sie z.B. ausgebildet gemäss Fig. 1, Fig. 2 oder Fig. 14, als Drehmagazin bezeichnet.

Beim Chargieren oder Dechargieren von Werkstücken an Drehmagazinen ist es üblich, die Drehmagazine an der Behandlungskammer angekoppelt zu belassen. Dies aufgrund der signaltechnischen Verbindungen, wie von Motorantrieb, elektrischer Signale zur Biaslegung der Werkstücke, von Kühlmediumleitungen etc. Wie sich auch im Folgenden ergeben wird, sind die der vorliegenden Erfindung unter einem Aspekt zugrundegelegten Mehrkammeranlagen darauf ausgelegt, Drehmagazine als Ganzes, entsprechend einer Batch-Behandlung, zu handhaben. Davon ausgehend ist das Problem zu lösen, die mechanische Drehkopplung gemäss A wie auch gegebenenfalls eine elektrische Signal-Ankopplung, insbesondere zur Bias-Versorgung der Werkstücke, an die Drehmagazine zu realisieren, die es erlaubt, die erwähnten Drehmagazine als Ganzes zu handhaben, dabei insbesondere auch als Ganzes zu chargieren bzw. zu dechargieren: Die Kopplung muss sich eignen, automatisch erstellt bzw. gelöst zu werden. Bedenkt man, beispielsweise mit Blick auf ein Drehmagazin gemäss Fig. 14, der Zeitverhältnisse, die gebraucht werden, um dieses mit Werkstücken einzeln zu chargieren, wenn es an einer Anlagekammer angekoppelt bleibt, so ergibt sich ohne weiteres der bezüglich Anlagestillstandzeiten und Durchlauf wesentliche Vorteil, der sich ergibt, wenn die erwähnten Drehmagazine als Ganzes gehandhabt, d.h. transportiert und dabei auch chargiert bzw. dechargiert werden können.

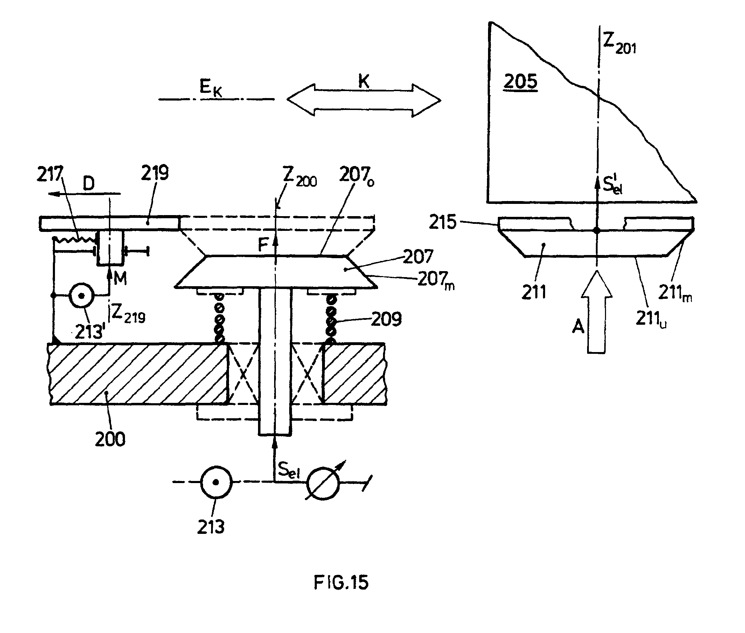

In Fig. 15 ist eine bevorzugte Ausführungsform einer elektrischen und/oder Drehantriebs-Kopplung dargestellt, grundsätzlich zwischen stationären Anlageteilen und einem als Ganzes gehandhabten Drehmagazin wirkend.

An einer Wandungspartie 200 einer Vakuumbehandlungskammer ist, bezüglich einer Kammerachse $Z_{200}$ - entsprechend der Position, in welcher die Drehachse $Z_{201}$ eines einzufahrenden Drehmagazines 205 zu positionieren ist - ein Kegelstumpfrad 207 vorgesehen.

Mindestens die kleine Kegel-Stirnfläche $207_o$ ist elektrisch leitend, bevorzugterweise auch die Kegelstumpf-Mantelfläche $207_m$. Bevorzugt ist das Kegelstumpfrad 207 als Ganzes aus elektrisch leitendem Material.

Das Kegelstumpfrad 207 wird mit dem elektrischen Signal $S_{el}$ beaufschlagt, entsprechend einer den Werkstücken am Drehmagazin 205 aufzulegenden Spannung. Eine Druckfederanordnung 209 spannt das Kegelrad 207 gemäss Pfeil F nach aussen.

Das schematisch dargestellte Drehmagazin 205 weist, z.B. auch zur Übernahme des Drehantriebes A in Analogie zu den Fig. 1, 2, 14, ein am.Magazin 205 befestigtes oder drehgelagertes (je nach Ausbildungsform des Drehmagazines) Kegelstumpfrad 211 auf, woran mindestens die kleinere Stirnfläche $211_u$, vorzugsweise auch die Kegelstumpfmantelfläche $211_m$, aus elektrisch leitendem Material gefertigt ist. Vorzugsweise ist wiederum das ganze Kegelstumpfrad 211 aus elektrisch leitendem Material. Wie schematisch mit $S'_{el}$ dargestellt, besteht eine elektrische Verbindung vom Kegelstumpfrad 211 letztendlich zu den Werkstücken am Drehmagazin 205.

Zum Erstellen und entsprechend zum Lösen der elektrischen Kopplung zwischen den Signalpfaden für $S_{el}$ und $S'_{el}$ wird das Drehmagazin 205 in der mit K bezeichneten Kopplungs-/Entkopplungs-Richtung bewegt, vorzugsweise in einer Ebene, und weiter bevorzugt linear, derart, dass die Mantelfläche $211_m$ auf die Mantelfläche $207_m$ aufstösst, worauf, durch Weiterbewegung des Drehmagazines 205, das Kegelrad 207 gegen die Kraft der Feder 209 rückgestellt wird und erst über die Mantelflächen, dann abschliessend über die kleinen Kegelstirnflächen $207_o$ bzw.

$211_u$ die elektrische Kopplung erstellt wird. Gestrichelt ist in Fig. 15 die eingekoppelte Lage des Kegelstumpfrades 211 dargestellt.

Bis anhin wurde ausschliesslich das Vorgehen zum Erstellen der elektrischen Kopplung diskutiert. Es sind nun bezüglich relativer Drehbewegung der Kegelräder 207 und 211 verschiedene Fälle möglich:

- Wird das Drehmagazin 205 bezüglich des Kegelstumpfrades 211 andersweitig in Drehbewegung versetzt, als in Fig. 15 mit A bezeichnet, und ist mithin das Kegelrad 211 am Drehmagazin 205 frei drehgelagert, so verbleibt das Kegelstumpfrad 211 am Kegelstumpfrad 207 stationär, wirkt lediglich als Übertragungskontaktelement.

- Soll das Kegelstumpfrad 211 entsprechend A und damit mindestens Teile des Drehmagazines 205 in Drehbewegung versetzt werden, so kann dies dadurch erfolgen, dass das an der Kammerwand 200 federgespannte Kegelstumpfrad 207 drehgelagert ist und mittels eines Antriebsmotors 213 angetrieben wird (gestrichelt dargestellt). Die Kontaktflächen der Räder 207, 211 sind in diesem Fall bevorzugterweise profiliert und wirken als antriebsübertragende Haftflächen.

- Wird in der gestrichelt eingetragenen Position des Kegelstumpfrades 211, dessen Antrieb, wie noch zu erläutern sein wird, nicht über Kegelstumpfrad 207 erstellt, so sind wiederum zwei Fälle möglich, entweder schleift das Rad 211 am drehfesten Rad 207, oder - und bevorzugt - es ist das Rad 207 als Freilaufrad ausgebildet und dreht, mit dem getriebenen Rad 211 in gestrichelter Position, um die Achse $Z_{200}$.

Bevorzugt wird ein Auftrennen der Funktionen Drehantriebsübertragung und elektrische Signalübertragung zwischen den Kegelstumpfrädern 207 und 211. Dies wird in bevorzugter Ausführungsform wie weiter in Fig. 15 dargestellt realisiert. Das Kegelstumpfrad 211 trägt einen Antriebskranz 215, ausgebildet als Verzahnungskranz oder als Reibkontaktkranz. Wenn das Kegelstumpfrad 211 mit dem Antriebskranz 215 und dem Drehmagazin 205 in Kopplungsposition gegen die Achse $Z_{200}$ gemäss K bewegt wird, so tritt der Antriebskranz 215 mit einem kammerseitigen Antriebsrad 219 in Kontakt. Das Antriebsrad 219 ist bezüglich der Kammerwand 200 um Achse $Z_{219}$ drehgelagert, wobei die Achse $Z_{219}$, mittels einer schematisch dargestellten Federanordnung 217 federgespannt, parallel zur Bewegungsebene $E_K$ und, in Richtung der Drehmagazinbewegung K, verschieblich ist. Der Antriebskranz 215 tritt somit mit dem Antriebsrad 219 während der Kopplungserstellung in Kontakt und drückt das Antriebsrad 219 in eingetragener Richtung D gegen die Kraft der Federanordnung 217. Dabei wird die Antriebskopplung erstellt. Entsprechend dem Antriebskranz 215 ist das Antriebsrad 219 als Reibrad oder - und bevorzugt - als Zahnrad ausgebildet. Es wird, ggf. über ein Getriebe, von einem Antriebsmotor 213', wie mit dem Signal M dargestellt, angetrieben und treibt durch Reiboder Verzahnungskontakt das Kegelstumpfrad 211 an. Dabei kann das Kegelstumpfrad 207, bei stationärem Einbau bezüglich der Wand 200, den elektrischen Kontakt reibend sicherstellen, oder ist, bevorzugt, als Freilaufrad ausgebildet, mit dem Kegelstumpfrad 211 frei umlaufend.

Mit der anhand von Fig. 15 dargestellten Kopplungsanordnung wird es möglich, in Mehrkammeranlagen der nachfolgend beschriebenen Art, aber auch in Einzelkammeranlagen, Werkstückdrehmagazine, wie z.B. 205 von Fig. 15, als Ganzes von einer Kammer zur andern zu transportieren, zu chargieren bzw. zu dechargieren und dabei automatisch die geforderte mechanische und/oder elektrische Kopplung zu erstellen bzw. zu lösen.

Bei allen nachfolgend beschriebenen Anlagekonfigurationen wird das Kopplungsproblem zu den entsprechend vorgesehenen Drehmagazinen bzw. Werkstückträgern bevorzugt wie anhand von Fig. 15 erläutert wurde gelöst.

Wie im weiteren in den Fig. 1 und 2 gestrichelt dargestellt, aber durchaus auch am Werkstückträger gemäss Fig. 14 realisierbar, sind mit den Werkstückträgern 1 bzw. 20, generell mit Drehmagazinen 205 gemäss Fig. 15, jeweils eine Abstützplatte 21 und insbesondere die nachfolgend noch zu beschreibende Dichtplatte 49 so verbunden, dass die Werkstückträger an den Abstützplatten 21 drehbeweglich gelagert sind. Wie ersichtlich sein wird, wird dadurch eine Werkstückträgeranordnung geschaffen, die gleichzeitig ermöglicht, die jeweils damit beschickten Behandlungskammern, mit der Dichtplatte 49, prozesstechnisch von der Verteilkammer abzutrennen bzw. generell erlaubt, eine mit einem Werkstückträger bediente Kammeröffnung prozesstechnisch zu schliessen.

In den nachfolgenden Figuren, d.h. allen nachfolgend vorgestellten, erfindungsgemässen Anlagen können Werkstückträger des in Fig. 1 und/oder Fig. 2 und/oder Fig. 14 bzw. Drehmagazine 205 der dargestellten Typen eingesetzt werden.

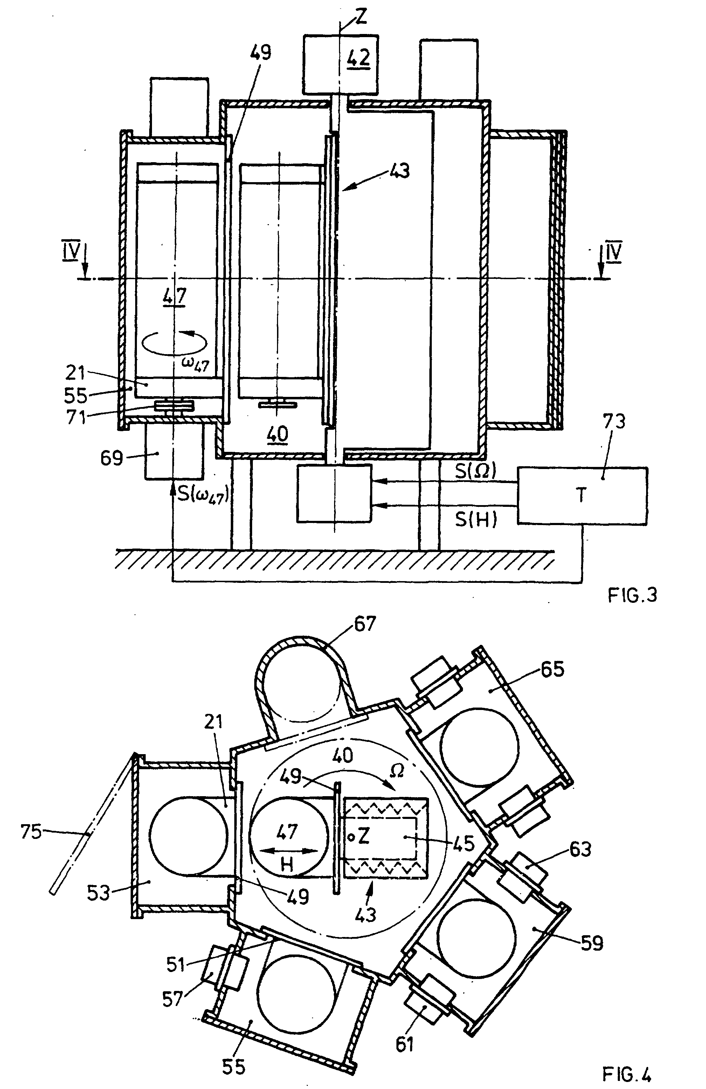

Die in den Fig. 3 und 4 dargestellte Anlage weist eine zentrale Verteilkammer 40 auf. In der Verteilkammer 40 ist, um eine Zentralachse Z mittels eines Antriebs 42 drehbar, ein Transportroboter 43 vorgesehen. Der Transportroboter 43 weist, wie aus Fig. 4 ersichtlich, einen radial bezüglich der Achse Z ausfahrbaren Arm 45 auf, der bei Bedarf bezüglich Umgebung in der Verteilkammer balggekapselt ist. Der Arm 45 kann jeweils einen dem Prinzip nach Fig. 1, Fig. 2 oder Fig. 14 entsprechend aufgebauten, zylindrischen Werkstückträger 47 transportieren. In der hier dargestellten Ausführungsform, und wie insbesondere aus Fig. 3 ersichtlich, ist am Werkstückträger 47 die Dichtungsplatte 49 (Fig. 1, 2) angeordnet und wird als Einheit mit dem Werkstückträger 47 transportiert. An Bedienungsöffnungen 51 an der Verteilkammer 40, die auf die horizontale Hubebene des Armes 45 ausgerichtet sind, sind mindestens eine Ein-/ Ausschleuskammer 53 oder je mindestens eine Ein- und eine Ausschleuskammer angeflanscht, sowie Behandlungskammern, dabei vorzugsweise mindestens eine Beschichtungskammer, wie z.B. eine Sputterkammer 55 mit einer Sputterquelle 57, eine weitere 59 mit zwei Sputterquellen 61 und 63, eine weitere 65 und eine Kühlkammer 67.

In Fig. 4 sind die Kammern 53, 55, 59 und 65 beladen, während die Kammer 67 eben entladen wurde.

Es ist ersichtlich, dass bei dieser Anlagenkonfiguration, solange ein Werkstückträger 47 in einer jeweiligen Kammer abgelegt ist, auch gleichzeitig, mit der Dichtungsplatte 49 die entsprechende Öffnung 51 zur Verteilkammer 40 abgeschottet ist.

Wie aus Fig. 3 ersichtlich, wird insbesondere bei Kammern mit gerichteter Behandlungswirkung, wie beispielsweise bei den Sputterkammern 55 und/oder 59 und/oder 65 jeweils ein Drehantrieb 69 mit Antriebskopplung 71 vorgesehen, um dort, wie anhand von Fig. 1, 2 oder 14 erläutert wurde, mindestens Teile des Werkstückträgers 47 in Drehbewegung zu versetzen. Bevorzugt wird die anhand von Fig. 15 erläuterte Kopplungstechnik eingesetzt.

Wie aus Fig. 4 weiter ersichtlich, ist die Kammer 67 durch Entnahme des vormals darin behandelten Werkstückträgers 47, und damit gleichzeitig der Dichtwand 49, gegen die Verteilkammer 40 offen.

Im weiteren ist an der Anlage eine Zeitsteuereinheit 73 vorgesehen, welche u.a. die Drehbewegung des Transportroboters 43 entsprechend $S(\Omega)$, die Hubbewegung des Transportarmes 45 entsprechend $S(H)$ und die Drehbewegung des Werkstückträgers 47 entsprechend $S(\omega 47)$ ansteuert. Für die Abscheidung von Verschleissschutz-Schichtsystemen werden an den Beschichtungskammern, wie den in Fig. 3 und 4 dargestellten Sputterkammern, Verschleissschutz-Schichtmaterialien aufgebracht, jeweils durch PVD- oder PECVD-Beschichtungsverfahren. Dabei können die PVD-Beschichtungsverfahren als reaktive Verfahren durchgeführt werden, wozu den entsprechenden Kammern aus einem Gasvorrat Reaktivgas zugeführt wird. Sie können aber auch nicht-reaktiv realisiert werden. Zum Ablegen von Verschleissschutzsystemen erfolgt der Arbeitszyklus in der mit $\Omega$ in Fig. 4 angegebenen Abfolge, gesteuert durch die Einheit 73, d.h. Vorbehandeln in der Kammer 67 und anschliessendes Ätzen - reaktiv oder nichtreaktiv - und Beschichten, reaktiv oder nichtreaktiv.

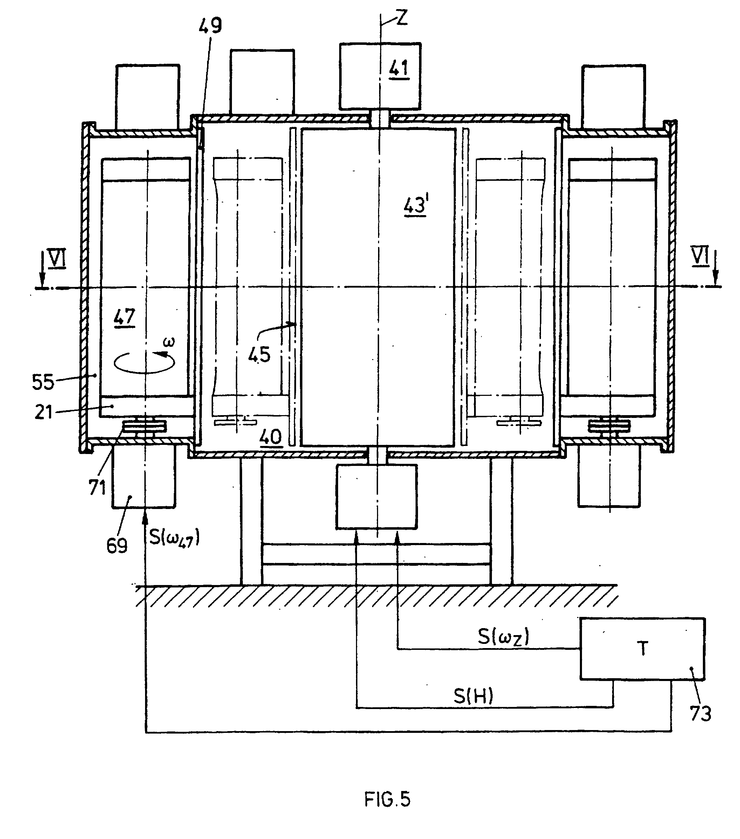

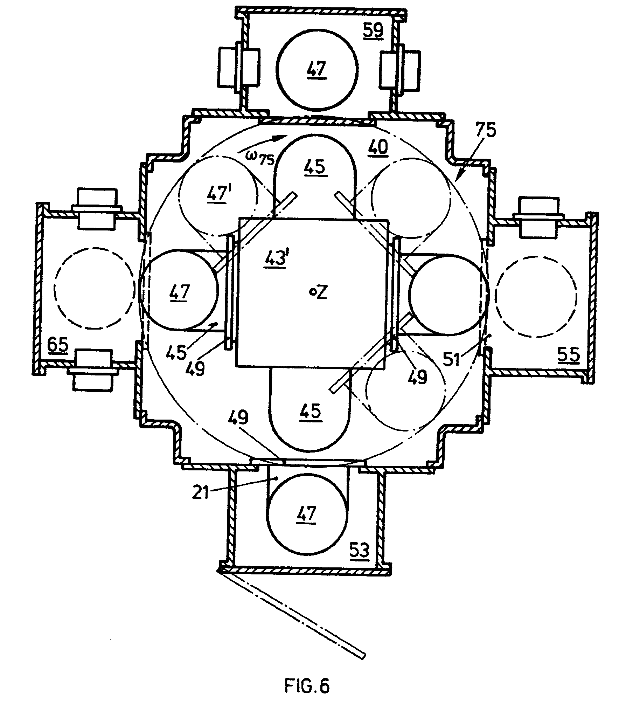

In den Fig. 5 und 6 ist eine weitere erfindungsgemässe Anlagenkonfiguration dargestellt, welche für den Fachmann, nach den Erläuterungen zu Fig. 3 und 4, keiner weiteren wesentlichen Erläuterungen bedarf. Es sind bereits anhand von Fig. 3 und 4 erläuterte Teile mit denselben Bezugszeichen versehen. Der Unterschied der Anlage gemäss den Fig. 5 und 6 zur Anlage gemäss den Fig. 3 und 4 ist, dass der Transportroboter 43' gemäss den Fig. 5 und 6 mehrere Transportarme 45 aufweist und mithin die an der zentralen Verteilkammer 40 vorgesehenen Kammern mit erhöhter Taktfrequenz bedienen kann.

Dabei können, über die Zeitsteuereinheit 73, die mehreren am Roboter 43' vorgesehenen Arme 45 (siehe Fig. 6) vorzugsweise in beliebig eingebbarer Abfolge ausgefahren bzw. rückgeholt werden.

Beispielsweise sind in den Fig. 5 und 6 die Kammern 53 und 59 jeweils betriebsbereit mit Werkstückträgern 47 beladen und mit den Platten 49 abgedichtet, während die Kammern 65 und 55 eben entladen bzw. beladen werden. Oft wird aber eine synchrone, gleichzeitige Bedienung der Kammern erwünscht sein.

Anhand insbesondere von Fig. 6 wird auch ohne weiteres eine weitere Realisationsmöglichkeit ersichtlich. Bei ihr kann der Transportroboter 43' wie bis anhin beschrieben um die Achse Z gesteuert drehbar sein, oder aber in der Verteilkammer 40 ortsfest angeordnet sein. Der Transport der Werkstückträger 47 erfolgt in der Verteilkammer 40 in letzterwähntem Fall, wie bei 47' dargestellt, mittels eines Karussells, jeweils in Ausrichtposition zu einem der Arme 45 und einer der Öffnungen 51. Mit den Armen 45 wird lediglich die Transportbewegung radial vom Karussell in und aus den Kammern zurück zum Karussell realisiert. Die Drehbewegung eines derart vorgesehenen Karussells 75 ist in Fig. 6 mit $\omega_{75}$ angedeutet. Gar weiter erhöhte Flexibilität der Kammerbedienung wird bei Einsatz eines Karussells 47' sowie eines um Z drehbaren Roboters 43' erzielt.

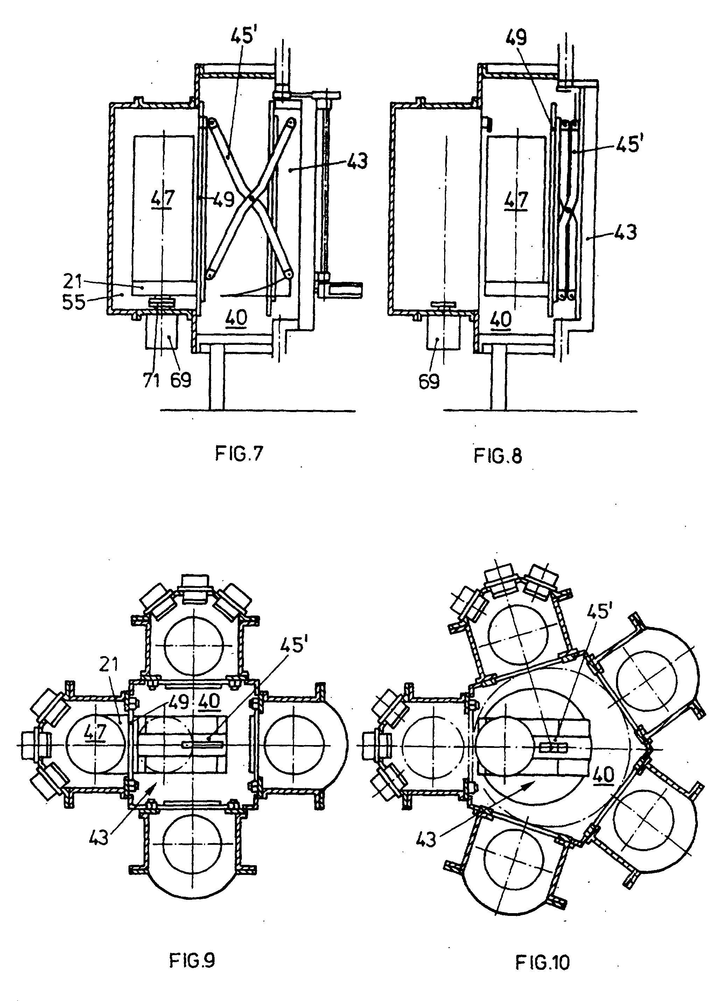

In den Fig. 7 bis 10 ist eine weitere erfindungsgemässe Anlage dargestellt, in Fig. 9 in der Konstellation mit vier an die Verteilkammer 40 angeflanschten Kammern, in der Konstellation gemäss Fig. 10 mit fünf derartigen Kammern. Wiederum wird aus dem bisher Gesagten der Aufbau und die Funktionsweise der hier dargestellten Anlage dem Fachmann ohne weiteres klar. Es sind wiederum dieselben Bezugszeichen für dieselben Teile bzw. Aggregate eingesetzt, die bereits bei den Fig. 3 bis 6 verwendet wurden. Der wesentliche Unterschied der in den Fig. 7 bis 10 dargestellten Anlage ist der Aufbau des am zentralen Roboter 43 vorgesehenen Radialhub-Transportorgans.

Wie insbesondere aus den Fig. 7 und 8 ersichtlich, sind am zentralen Roboter 43 - in der Konfiguration prinzipiell nach den Figuren 3 und 4 eine, in einer Konfiguration nach den Fig. 5 und 6 mehrere - Scherenmechanik-Hebelanordnungen 45' vorgesehen, um die Werkstückträger 47 mit den Dichtungsplatten 49 gegen und in die jeweiligen Behandlungskammern bzw. aus ihnen zu transportieren. In Fig. 9 ist die Mechanik 45' ausgefahren dargestellt, in Fig. 10 rückgeholt, analog zu den Fig. 7 und 8.

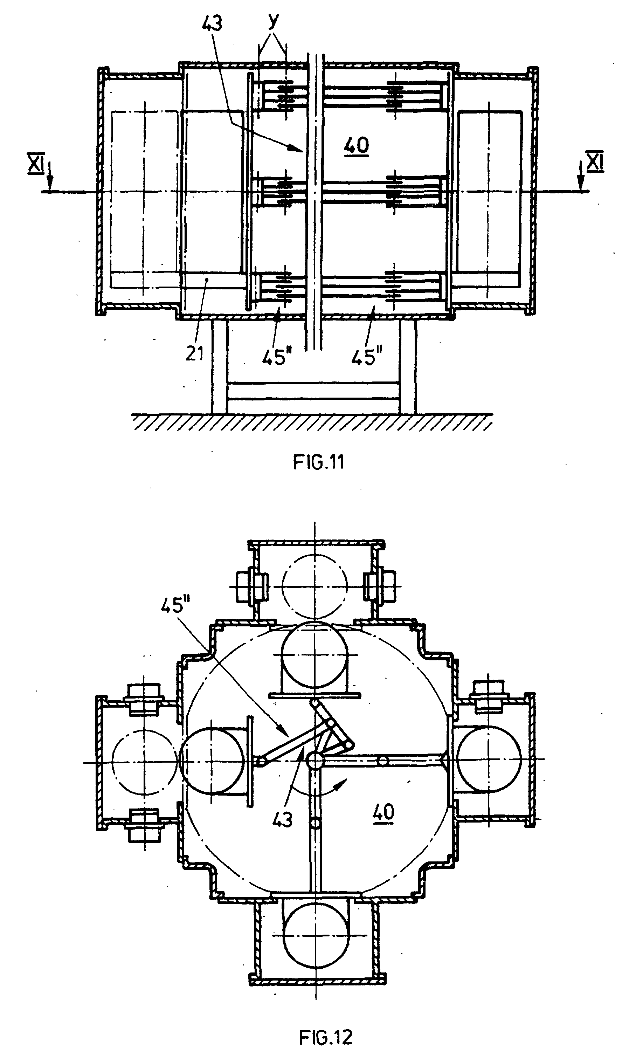

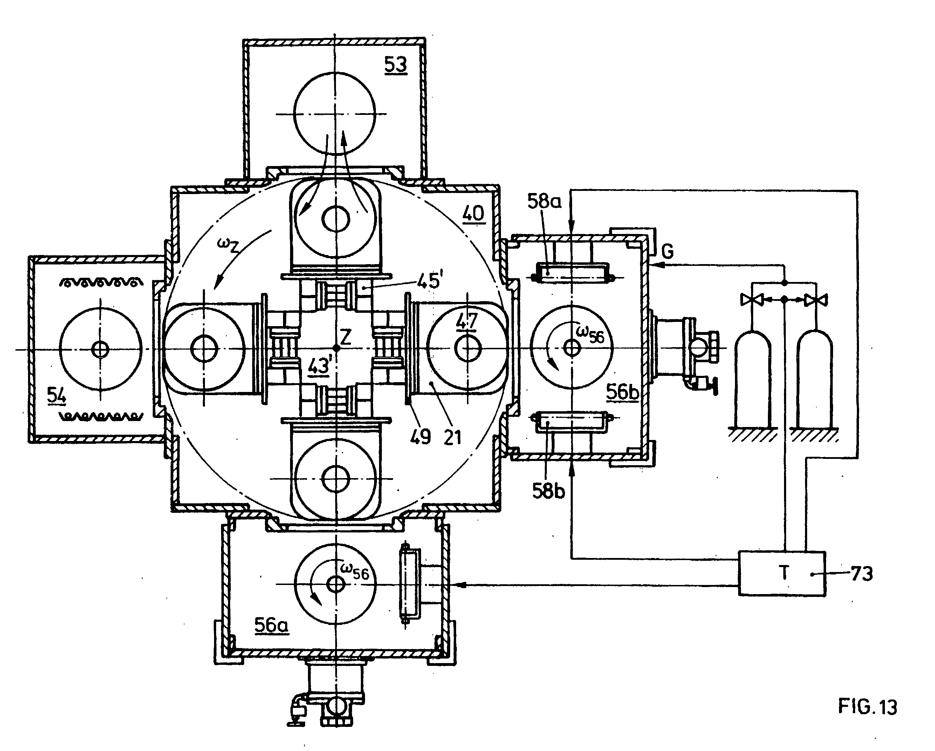

Anstelle von linear radial ausfahrbaren Transportarmen 45, wie sie an den Anlagen gemäss den Figuren 3 bis 6 vorgesehen sind, oder von radialen Ausfahrorganen in Form von Scherenmechaniken, wie sie anhand der Fig. 7 bis 10 und im weiteren auch gemäss Fig. 13 vorgesehen sind, können weitere Huborgan-Strukturen vorgesehen sein, beispielsweise, wie sie an der Anlage gemäss den Fig. 11 und 12 dargestellt sind, wo die radialen Huborgane 45" mittels mehrarmiger Hebelanordnungen realisiert sind, welche gegenseitig um vertikale Achsen Y schwenkbar sind. Der Aufbau der Anlage gemäss den Figuren 11 und 12 entspricht, abgesehen vom erwähnten Radialhub-Mechanismus, dem Aufbau der bereits anhand der Figuren 3 bis 10 beschriebenen Anlagen.

In Fig. 13 ist die Konfiguration einer Anlage dargestellt, die, praktisch in Minimalkonfiguration, sich insbesondere für das Ablegen eines Verschleissschutz-Schichtsystems auf Werkstücke, insbesondere auf Werkzeuge für die spanabhebende Bearbeitung oder auf Maschinenbauelemente eignet.

Die Anlage gemäss Fig. 13 weist in der Verteilkammer 40 einen um die Zentralachse Z drehbaren Transportroboter 43' mit vier Scherenmechanik-Hubarmen 45' auf, ausgebildet, wie anhand der Fig. 7 und 8 dargelegt wurde. Werkstückträger 47 werden, gemeinsam mit Hubplatten 21 und Dichtungsplatten 49 transportiert, in den vorgesehenen Kammern abgelegt bzw. aus letzteren rückgeholt. Es sind eine Bedienungs- bzw. Schleusenkammer 53, eine Vorbehandlungs-, insbesondere Heizkammer 54 und mindestens eine, am dargestellten Beispiel zwei, Beschichtungskammern 56a, 56b vorgesehen. Der Behandlungszyklus erfolgt vorzugsweise in der mit $\omega_Z$ angegebenen Richtung. Auch hier ist eine Zeitsteuereinheit 73, wie sie bereits in den Fig. 3 bzw. 5 eingeführt wurde, vorgesehen, welche ggf. frei programmierbar die zeitlich voneinander abhängigen Operationen an der Anlage steuert. Insbesondere in den Kammern 56a and 56b werden die Werkstückträger 47, wie mit $\omega_{56}$ dargestellt, in Drehung versetzt, bevorzugterweise daran, und wie anhand von Fig. 2 erläutert wurde, auch die Werkstückaufnahmen für die Werkstücke.

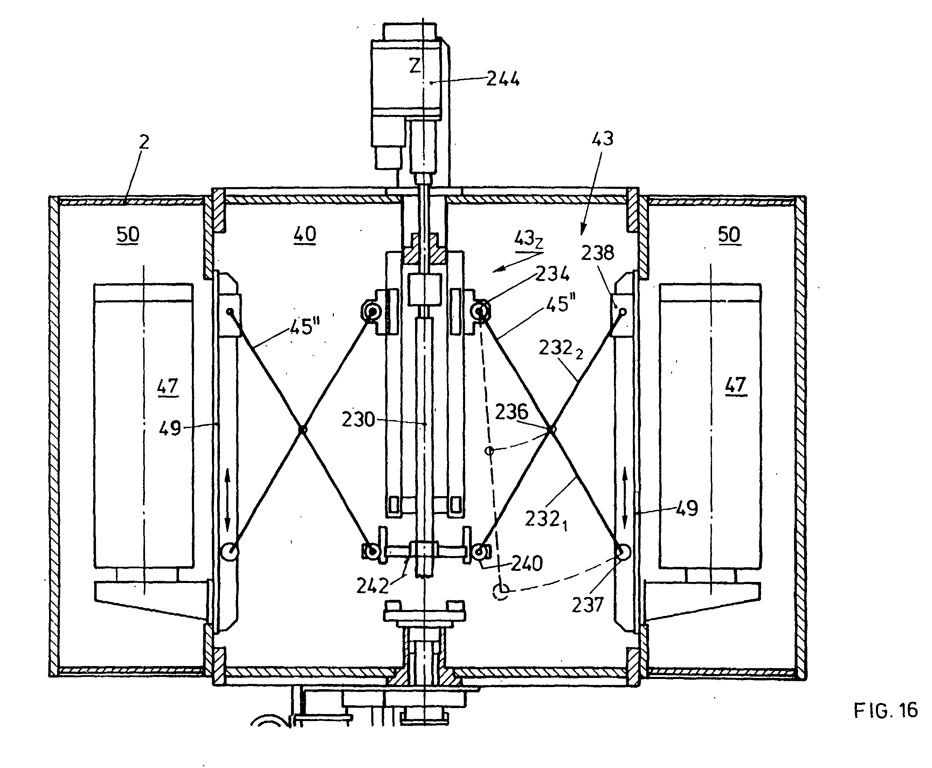

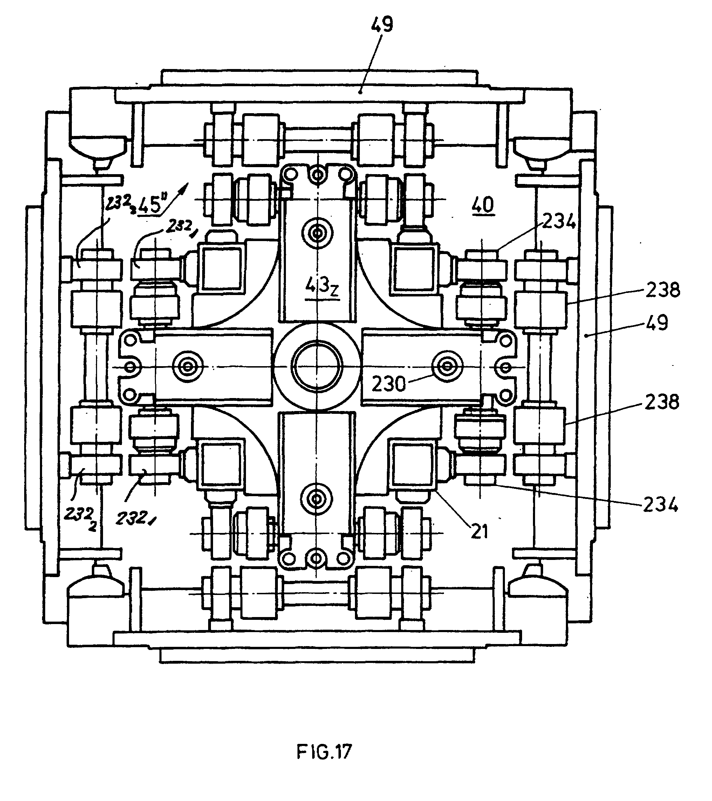

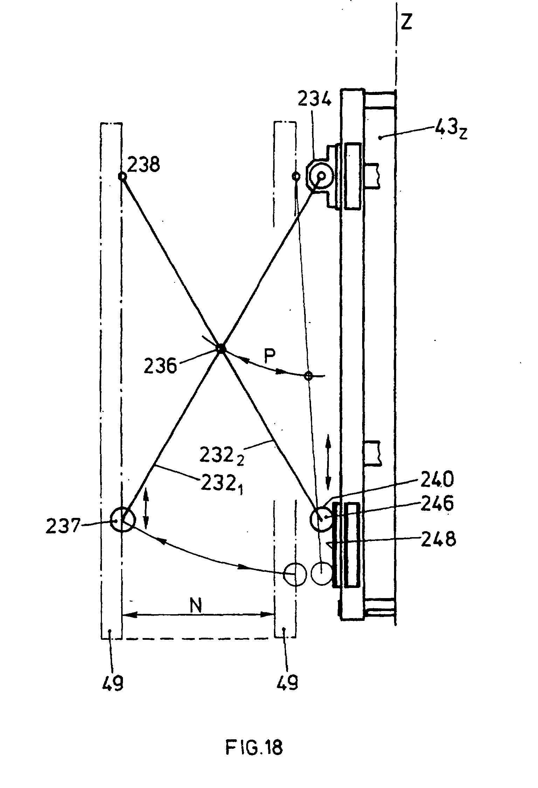

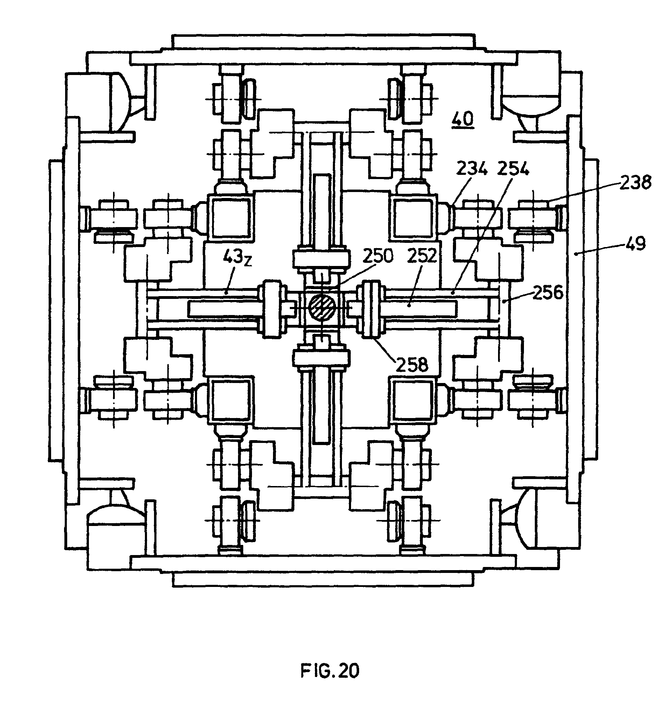

Anhand der Fig. 16 und 17 einerseits, anderseits der Fig. 18 bis 20, sollen zwei bevorzugte Ausführungsformen der Scherenmechanikantriebe 45' an Anlagen, wie sie bereits anhand der Fig. 7 bis 10 prinzipiell erläutert wurden, vorgestellt werden. Es werden für bereits anhand der Fig. 7 bis 10 beschriebene Teile dieselben Bezugszeichen verwendet.

Am zentralen Roboterteil $43_Z$ sind, über jeweils eine Scherenmechanik-Hebelanordnung 45", Werkstückträger 47 mit den zugeordneten Dichtungsplatten 49 vorgesehen. Im Zusammenhang mit den Fig. 16 bis 20 interessiert vornehmlich die Realisation und der Antrieb der Scherenmechanik-Hebelanordnungen 45". Deshalb werden davon nicht betroffene Anlageteile in diesem Zusammenhang nicht mehr weiter beschrieben.

An dem um die Achse Z getrieben drehgelagerten, zentralen Teil $43_Z$ des Roboters 43 sind, entsprechend der Anzahl vorgesehener Kammern, generell mit 50 bezeichnet, Scherenmechanik-Hebelanordnungen 45" vorgesehen. Während diese in Fig. 16 in Seitenansicht schematisiert dargestellt sind, aus Übersichtsgründen, sind sie in Fig. 17 in einer teilweise geschnittenen Querschnittsdarstellung, detaillierter dargestellt.

Im zentralen Roboterteil $43_Z$ ist für mindestens zwei Scherenmechanik-Hebelänordnungen gemeinsam oder, und bevorzugt, für jede der vorgesehenen Hebelanordnungen einzeln, ein Linearantrieb, z.B. mit einer Zugstange oder vorzugsweise mit einem Spindelantrieb 230, vorgesehen.

Ein erster, gemäss Fig. 17 vorzugsweise als Doppelhebel ausgeführter Hebel $232_1$ ist, wie aus Fig. 16 ersichtlich, an seinem oberen Ende am zentralen Teil $43_Z$ bei 234 schwenkgelagert. Sein unteres Ende liegt mittels auf/ab-laufender Rollen 237, vorzugsweise geführt, an der Dichtplatte 49.

Ein zweiter Hebel $232_2$ der Scherenmechanik ist bei 236 mit dem ersterwähnten Hebel $232_1$ so schwenkgelagert, dass beide Hebel $232_1$ und $232_2$ gleich lange Schenkel zwischen dem zentralen Drehlager 236 und den jeweiligen endständigen Lagern aufweisen. Der Hebel $232_2$ ist an seinem oberen Ende bei 238 an der Dichtplatt 49 schwenkgelagert, während sein unteres Ende bei 240 an einem mit dem Spindelantrieb 230 linear entlang dem Teil $43_Z$ auf/ab-getriebenen Schlitten 242 schwenkgelagert ist.

Angetrieben durch einen Antrieb 244 wird, selektiv, der jeweilige Spindelantrieb 230 für eine Scherenmechanik-Hebelanordnung 45" in Gang gesetzt, womit sich der Schlitten 242 linear in Richtung der Achse Z hebt oder senkt. Aufgrund der gleich langen Schenkel, jeweils zwischen Drehlager 236 und den Endlagerstellen der Hebel $232_1$ und $232_2$, ist sichergestellt, dass die Dichtplatte 49 parallel zur Achse Z und diesbezüglich linear ausgefahren bzw. rückgeholt wird.

In Fig. 16 ist gestrichelt der Hebel $232_1$ in derjenigen Position eingetragen, in welcher die Dichtplatte 49 vollständig abgehoben und rückgefahren ist. Es sind, weiter gestrichelt, die Kreisbahn der Rollen 237 sowie des Lagers 236 eingetragen.

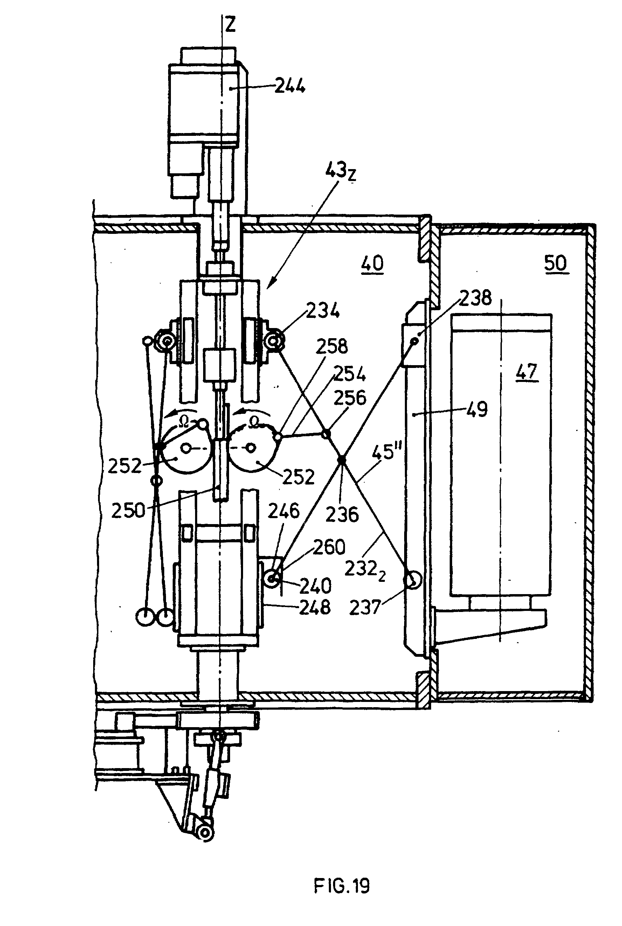

Die Realisation einer weiteren Antriebsvariante ergibt sich aus der schematischen Darstellung von Fig. 19.

Die Schwenklager 234 der gleichschenkligen Anordnung 45" mit zentralen Schwenklagern 236 sind wiederum unverschieblich am Teil $43_Z$ angeordnet. Für jede Scherenmechanik-Hebelanordnung 45", oder für mehrere oder alle gemeinsam, ist ein Lineartrieb vorzugsweise in Form einer Zahnstange oder Gewindestange 250 vorgesehen. Jede der Zahnstangen 250 steht in Eingriff mit der Verzahnung jeweils einer zugeordneten Kurbelscheibe 252, welche je am Teil $43_Z$ verschiebefest drehgelagert sind. Die Kurbelscheiben 252 sind je mittels Übertragungshebeln 254 mit den jeweiligen Hebeln $232_2$ verbunden, über Schwenklager 256 hebelseitig bzw. 258 kurbelscheibenseitig. Die Schwenklager 240 werden mittels vorzugsweise geführter Rollen 246 gebildet, welche entlang den Rollbereichen 248 am zentralen Teil $43_Z$ abrollen. Ein Abheben der Rollen 246 wird beispielsweise, und wie schematisch dargestellt, durch Führungen 260 verunmöglicht.

Während die Kammer 50 gemäss Fig. 19 rechts mit der Dichtplatte 49 verschlossen ist und somit die Scherenmechanik-Hebelanordnung 45" ausgefahren ist, ist letztere in Fig. 19 links rückgeholt, wobei dort Kammer und Dichtplatte nicht mehr gezeichnet sind. Mit Ω ist an den Kurbelscheiben 252 der jeweilige Drehsinn eingetragen, um sie zwischen den Positionen zu schwenken, an welchen die Scherenmechanik-Hebelanordnungen 45" vollständig ein- bzw. vollständig ausgefahren sind.

Der Vorteil dieses.Scherenmechanik-Hebelantriebes liegt insbesondere in der günstigen Antriebscharakteristik, d.h. dass das Übersetzungsverhältnis in der jeweiligen Scherenposition besser dem Bedarf angepasst ist als bei der Ausführungsform gemäss Fig. 16 und 17. Dies hat eine deutliche Reduktion der erforderlichen Antriebskräfte, damit der Momentenbelastungen und übertragenen Kräfte, zur Folge, womit auch der Antrieb 244 kostengünstiger ausgeführt werden kann, ggf. als Druckzylinder. Dabei reduziert sich der Steuerungsaufwand wesentlich.

In Fig. 18 ist schematisch die Bewegung der Scherenmechanik-Hebelanordnungen gemäss den Fig. 16 bzw. 19 dargestellt. Ob sie mit den linearen Antrieben, welche gemäss der Ausführungsform nach Fig. 16 auf den Schlitten 242 und damit die Lager 240 wirken, oder mit dem Antrieb nach Fig. 19, bei welchem direkt auf den Schwenkwinkel der Hebel $232_2$ eingewirkt wird, angetrieben werden, in beiden Fällen sind am zentralen Teil $43_Z$ die Lager 234 verschiebefest angeordnet. Die Lager 240 werden jedenfalls linear parallel zur Achse Z auf und ab verschoben, sei dies bei der Ausführungsvariante nach Fig. 16 angetrieben über den Schlitten 242 oder, gemäss Ausführungsvariante nach Fig. 19, freilaufend, wie dies in Fig. 18 mit den Rollen 246 und den Rollbereichen 248 auch dargestellt ist.

Dichtplattenseitig sind die Lager 238 verschiebefest angeordnet, während die Lager 237 wiederum auf und ab verschieblich sind, sowohl bei der Ausführungsform nach Fig. 19 wie auch bei derjenigen nach Fig. 16.

Es ist ersichtlich, dass sich die in Fig. 18 strichpunktiert eingetragene Dichtungsplatte 49 parallel und linear in Richtung N zur Achse Z ein- und auswärtsbewegt.

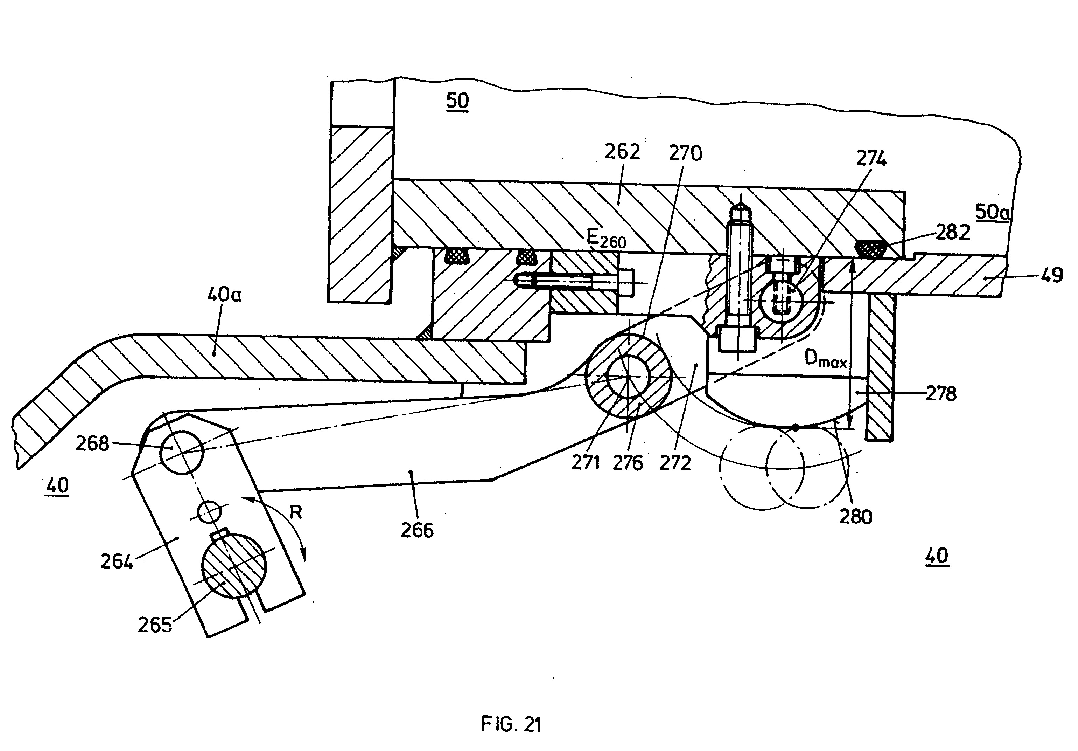

Wenn von Kammern 50, die an die zentrale Verteilkammer 40 angeschlossen sind und letzterer eine zu hohe Druckdifferenz, höher als ca. 4 mbar, vorherrscht, wird bevorzugterweise nebst den bis anhin beschriebenen Antrieben für die Dichtplatte 49 eine zusätzliche Dichtungssicherung vorgesehen. Diese soll anhand von Fig. 21 erläutert werden.

Das Vorsehen dieser Dichtungssicherung ist unabhängig vom Aufbau der Substratträger sowie der gewählten Vorschubmechanik und wird deshalb davon losgelöst erläutert.

In Fig. 21 ist ein Ausschnitt der Wandung $40_a$ der zentralen Vorteilkammer 40 dargestellt. Daran angeflanscht ist eine Kammer 50, wie z.B. eine Schleusenkammer, eine Beschichtungskammer, eine Heizkammer etc. Die Bedienungsöffnung 50a der Kammer 50 ist in einer Anschlussplatte 262 der Kammer 50 vorgesehen.

An der Verteilkammer ist ein Übertragungshebel 264 um eine Achse 265 drehgetrieben gelagert. Er ist, wie mit dem Doppelpfeil R dargestellt, getrieben hin und her schwenkbar. Sein der Achse 265 abgewandtes Ende ist an einem Lager 268 mit einem Übertragungshebel 266 gelenkig verbunden. Der Übertragungshebel 266, bevorzugterweise als Doppelhebel ausgebildet, ist an seinem dem Lager 268 gegenüberliegenden Ende 270 an einem weiteren Hebel 272 schwenkgelagert. Der Hebel 272 seinerseits ist an der Anschlussplatte 262 bei 274 schwenkgelagert.

Koaxial mit der Schwenkachse 271 zwischen den Hebeln 266 und 272 ist eine Anpressrolle 276 vorgesehen.

An der Dichtplatte 49 ist eine Kurvenscheibe 278 montiert, deren Kurvenfläche 280, mit Bezug auf die die Öffnung 50a gegen die Kammer 40 definierende Ebene $E_{260}$, und ausgehend von der Hebelanordnung 266/272, einen zunehmenden, ein Maximum $D_{max}$ durchlaufenden Abstand festlegt.

Ist die Dichtplatte 49 mittels einer der vorerwähnten Transporttechniken an eine vorzugsweise vorgesehene Dichtung 282 um die Öffnung 50a gelegt, so wird, motorisch über Achse 265 getrieben, der Hebel 264 gemäss Fig. 2 im Uhrzeigersinn geschwenkt, womit die Anpressrolle 276 über die Kurvenfläche 280 der Kurvenscheibe 278 getrieben wird, wie strichpunktiert dargestellt. Dies bis unmittelbar nach Durchlaufen des Abstandsmaximums $D_{max}$ bezüglich der Ebene $E_{260}$. Damit wird ein hoher dichtender Anpressdruck zwischen Dichtplatte 49 und Berandung der Öffnung 50a stabil sichergestellt, der auch ohne weiteres Differenzdrücken bis zu 1 bar dichtend widersteht. Wenn der $D_{max}$-Bereich durch die Rolle 276 durchlaufen ist, kann der Antrieb auf Hebel 264 stillgesetzt werden.

Bevorzugterweise wird aber die Rolle 276 nicht über einen durch $D_{max}$ definierten Totpunkt hinaus getrieben, insbesondere aus Verschleiss- und Abriebgründen. In diesem bevorzugten Fall wirkt der Antrieb über Achse 265 permanent und sichert somit durch aktives permanentes Spannen die notwendige Dichtkraft für die Dichtplatte 49.

Rückblickend auf alle vorgestellten Anlagenkonfigurationen, aber auch mit Blick auf eine Einkammeranlage, kann die anhand von Fig. 21 dargestellte Dichtungssicherung überall dort eingesetzt werden, wo eine Dichtplatte jeglicher Art lösbar und mit hohem Anpressdruck an eine Durchtrittsöffnung zwischen zwei auf unterschiedlichen Drücken betriebenen Kammern gelegt werden muss, wovon mindestens eine eine Vakuumkammer ist.

In Minimalkonfiguration für das Aufbringen von Verschleissschutz-Schichtsystemen umfasst die Anlage:

- die Bedienungskammer 53,

- die Vorbehandlungskammer 54 zum Aufheizen der Werkstücke, zu deren Ausgasen bzw. zum Zersetzen von Verunreinigungen an der Oberfläche und schliesslich zum Erreichen der in den Folgekammern notwendigen Beschichtungstemperatur.

Das Aufheizen in Kammer 54 kann durch Strahlungsheizung und/oder durch den Elektronenstrom einer in dieser Kammer erzeugten Glimmentladung bzw. Bogenentladung bei auf anodisches Potential gelegten Werkstücken erfolgen.

Im weiteren kann die Vorbehandlung in der Kammer 54 einen Ätzschritt umfassen, beispielsweise und bevorzugterweise durch Sputterätzen, bei dem die Werkstückoberflächen einem Ionenbeschuss ausgesetzt werden mit Argon-Ionen oder durch Metallionen beim Metallion-Ätzen bevorzugt mittels einer Arc-Quelle. Bevorzugt ist das Ionenätzen mittels Ar-Ionen.

Dadurch wird die metallische Werstückoberfläche von Oxyden oder sonstigen Kontaminationsschichten befreit und vorbereitet für die nachfolgende Beschichtung.

Schliesslich folgt in der erwähnten Minimalkonfiguration der Vorbehandlungskammer 54 eine Beschichtungskammer der Art, wie sie beispielsweise in Fig. 13 mit den Kammer 56a bzw. 56b dargestellt ist, woran die für das gewählte Beschichtungsverfahren notwendigen Quellen eingebaut sind. Wie mit der Kammer 56b dargestellt ist, können dabei mehrere Behandlungsprozesse, z.B. sequentiell hintereinander durchgeführte Beschichtungsprozesse mit Quellen $58_a$ bzw. $58_b$, durchgeführt werden und/oder Beschichtungsprozesse mit zwischengeschalteten Ätzprozessen. Durch Potentialführung insbesondere der Werkstücke und Einlass-Steuerung für unterschiedliche Gase G die in die Prozessatmosphäre, beispielsweise durch Umschalten zwischen dem Einlassen reaktiver Gase und reiner Edelgase, kann an ein und derselben Behandlungskammer, beispielsweise zwischen Sputterätzen und Sputterbeschichten, umgeschaltet werden.

Die Zeitsteuereinheit 73 steuert nebst den bereits vorbeschriebenen Anlagenbewegungen auch die Prozessführung, z.B. durch Eingriff auf die vorgesehenen Quellen und/oder Gasspeisungen für Prozessgas G.

In einer weiteren bevorzugten Betriebsweise einer erfindungsgemässen Anlage in Vierkammer-Konstellation, wie sie in Fig. 13 dargestellt ist, ist eine Bedienungskammer 53 vorgesehen für das Beladen und Entladen der Verteilkammer 40, eine Heizkammer 54, bei der nebst mittels Strahlungsheizung geheizt auch ein Ätzschritt vorgenommen wird, worauf in einer Mehrfunktionskammer der in Fig. 13 bei 56b dargestellten Art die weitere Behandlung vorgenommen wird, nämlich nochmaliges Ätzen durch Ar - oder Metallionenbeschuss während ca. 5 Minuten, dann Sputterbeschichten oder Beschichten mittels einer Arc-Quelle mit einer metallischen Haftschicht, vorzugsweise mit Chrom unter Verwendung einer Magnetronquelle, was ca. 20 Minuten dauert, dann Aufsputtern einer Zwischenschicht aus Wolframkarbid aus einer zweiten Magnetronquelle während etwa 30 Minuten. Schliesslich wird in der vierten Kammer die Funktionsschicht durch Sputtern von Wolframkarbid und gleichzeitigem Einlassen von Azetylen realisiert. Bei diesem Vorgehen werden, mit Blick auf Fig. 13 und Umlaufrichtung $\omega_Z$, die Kammern 56a und 56b vertauscht.

Die erfindungsgemässe Anlage wird insbesondere zur Abscheidung von Verschleissschutz-Schichten mittels PVD- oder Plasma-CVD-Verfahren eingesetzt.

Dabei werden folgende Verschleissschutz-Schichten bevorzugt abgelegt:

- Hartstoffschichten, z.B. aus TiN, TiCN, TiAlN, CrN und Schichtsysteme mit mehreren Schichten, beispielsweise der erwähnten Materialien;

- reibungsmindernde Schichten, wie z.B. wasserstoffhaltige Kohlenstoffschichten und wasserstofffreie Kohlenstoffschichten, Kohlenstoffnitrid-, Kohlenstoffsilizium-Schichten, Kohlenstoff-Silizium-Oxid-Schichten, Metallkohlenstoff-Schichten, Metallkarbid-Kohlenstoff-Schichten, Metallsulfid-Schichten und Schichtsysteme mit mehreren Schichten, beispielsweise der erwähnten Materialien.

Dabei werden die Hartstoffschichten bevorzugt auf Werkzeuge zum Zerspanen, wie Bohrer und Fräser, bzw. zum Umformen, wie Matrizen und Stempel, bei Temperaturen unter 550°C abgeschieden.

Die reibungsmindernden Schichten hingegen werden bevorzugt auf Präzisionsbauteile bei Temperaturen unter 250°C, wie Komponenten für Antriebsaggregate, Getriebe, Pumpen, eingesetzt, aber auch - bevorzugt in Kombination mit einer darunterliegenden Hartstpffschicht - auf Werkzeuge zum Zerspanen oder Umformen.

Beispiele für an der erfindungsgemässen Anlage erfindungsgemäss eingesetzte Beschichtungsprozesse:

- Sputtern von Wolframcarbid und gleichzeitiges Einlassen von Acetylen in die Prozesskammer zur Abscheidung von Wolframcarbid-Kohlenstoffschichten;

- Zersetzung von Acetylen mittels eines HF-Plasmas zur Abscheidung von wasserstoffhaltigen Kohlenstoffschichten.

Bei den oben erwähnten Plasmaprozessen können auch gepulste DC-Plasmen eingesetzt werden;

- Kathodisches Arc-Verdampfen von Graphittargets zur Abscheidung wasserstofffreier Kohlenstoffschichten.

Dabei kann beim Arc-Verdampfen der Plasmabogen durch einen Laser geführt werden, im Sinne einer Kombination von Laserablation und Arc-Verdampfen;

- reaktives, kathodisches Arc-Verdampfen einer Hartstoffschicht, wie TiAlN, und nachfolgendes Aufbringen einer wasserstofffreien Kohlenstoffschicht mit kathodischem Arc-Verdampfen eines Graphit-Targets zur Abscheidung einer Hartstoffschicht und einer reibungsmindernden Kohlenstoffschicht.

Dabei werden an der erfindungsgemässen Anlage in den jeweiligen Behandlungskammer beispielsweise folgende Behandlungen vorgenommen:

- Kammer 1:

  Be- und Entladen der Substrate und Abpumpen auf Prozessdruck

- Kammer 2:

  Vorbehandeln der Substrate, d.h.

- Aufheizen der Werkstücke zum Ausgasen bzw. Zersetzen von Verunreinigungen an ihrer Oberfläche und zum Erreichen der Beschichtungstemperatur. Das Aufheizen kann durch Strahlungsheizung erfolgen oder durch Elektronenbeschuss aus einer Plasmaentladung, wobei die Substrate als Anode gegenüber dem Plasma geschaltet sind.

- Ionenbeschuss der Werkstück-Oberflächen, bevorzugt mit Argon-Ionen oder aber mit Metallionen zum Ätzen der Oberfläche. Ziel des Ätzens ist es, eine metallische Werkstück-Oberfläche ohne oxydische oder sonstige Verbindungsschichten zu erzeugen, auf die die nachfolgend aufgebrachten Schichten ausreichend haften. Die Ionen werden in einer Plasmaentladung erzeugt.

- Kammer 3:

  Beschichten der Werkstücke. Diese Kammer enthält die für das gewählte Beschichtungsverfahren notwendigen Quellen. Dem Beschichtungsprozess ist unter Umständen ein weiterer Ätzschritt vorgeschaltet, um eine ausreichende Haftung der Verschleissschutz-Schicht auf dem Werkstück zu garantieren. Ein Teil des Beschichtungsprozesses kann dabei in einer weiteren Kammer 4 durchgeführt werden, um den Durchsatz an der erfindungsgemässen Anlage durch kürzere Taktzeiten zu erhöhen. Ansonsten dient eine Kammer 4 zum Abkühlen der Substrate vor dem Belüften.

Die erfindungsgemässe Anlage umfasst mithin mindestens drei Behandlungskammern. Dabei werden die Werkstücke in der zentralen Verteilkammer entweder synchron von einer Kammer in die andere verschoben oder über eine Zwischenkammer einzeln an die Behandlungskammern verteilt.

Nachfolgend ein besonders bevorzugtes Ausführungsbeispiel zum Betrieb der erfindungsgemässen Anlage in Vier-Kammer-Konstellation für den besonders bevorzugten Fall der Abscheidung einer Wolframcarbid-Kohlenstoffschicht. Grundsätzlich wird dabei beim Betrieb der erfindungsgemässen Anlage angestrebt, die einzelnen Behandlungsschritte so auf jeweilige Behandlungskammern zu verteilen, dass in jeder Behandlungskammer die Werkstücke im wesentlichen gleich lang behandelt werden, um damit eine synchrone Taktung der Anlage zu ermöglichen und um damit einen optimalen Durchsatz zu erzielen.

Kammer 1: Belüften, Entladen der bereits beschichteten Werkstücke, Beladen mit dem nächsten Werkstück-Batch und Abpumpen auf einen Druck $p_T$ für den gilt:

$$10^{-6} \text{ mbar} \leq p_T \leq 5 \cdot 10^{-2} \text{ mbar, typisch } p_T \cong 10^{-3} \text{ mbar.}$$

Dieser Druck entspricht dem in der Anlage herrschenden Druck. Der eingestellte Druck $p_T$ wird generell so gewählt, dass bei der Übergabe eine Kontamination der Substrate in den weiteren Kammern durch die neu eingeschleusten vermieden wird.

Dieser Schritt dauert 30 bis 60 Min.

Kammer 2: Heizen mit Strahlungsheizung während 15 bis 30 Min., dann Ätzen in einem Argon-Plasma oder in einem Metallionen-Plasma, wobei eine Werkstücktemperatur T

$$150°C \leq T \leq 250°C$$

eingehalten wird. Die Ätzrate beträgt 5 bis 50 nm pro Minute, abhängig von der Biasspannung der Werkstücke und dem Ionenstrom. Der Ätzschritt dauert wiederum 15 bis 30 Min.

Kammer 3: Nochmaliges Ätzen in einem Argon- oder Metallionen-Plasma, bevorzugt wiederum mittels Argon-Ionen, während 5 bis 10 Min. Danach Aufsputtern mittels einer Magnetronquelle einer Chromhaftschicht mit einer Dicke von 0,1 bis 1 µm sowie Aufsputtern einer Zwischenschicht aus Wolframcarbid mit einer Dikke von 0,1 bis 1 µm mittels einer zweiten Magnetronquelle. Jeder der erwähnten Beschichtungsschritte dauert bis 5 bis 30 Min.

Kammer 4: Abscheiden der Funktionsschicht durch Sputtern von Wolframcarbid unter gleichzeitigem Einlass von Acetylen. Es wird eine Funktionsschicht mit einer Dicke zwischen 1 und 5 µm abgelegt, Acetylen mit einem Fluss von 150 sccm bis 500 sccm eingelassen. Dieser Schritt dauert 30 bis 100 Min.

Die einzelnen Schrittlängen werden, wie erwähnt, vorzugsweise so aufeinander abgestimmt, dass die Werkstücke in jeder Kammer im wesentlichen gleich lang behandelt werden, so beispielsweise in jeder der vier Kammern ca. 50 Min.

**Patentansprüche**

1. Vakuumbeschichtungsanlage mit mindestens :

   - einer zentralen, evakuierbaren Verteilkammer mit einer im wesentlichen entlang einer Ebene gesteuert getriebenen Werkstück-Transportanordnung;

   - mindestens einer Bedienungskammer für die Verteilkammer sowie mindestens zwei Behandlungskammern für das Behandlungsgut, welche mindestens drei Kammern über Bedienungsöffnungen mit der Verteilkammer kommunizieren, durch welche Öffnungen Werkstücke von einer Kammer in die andere mittels der Transportanordnung transportierbar sind, **dadurch gekennzeichnet, dass**

   - Werkstückträger vorhanden sind, je mit einer Vielzahl Werkstückaufnahmen, wobei die Transportanordnung Werkstückträger transportiert und durch die Öffnungen die Werkstücke an Werkstückträgern transportierbar sind,

   - an mindestens einer der Behandlungskammern ein Antrieb und eine automatisch gesteuert erstellbare und lösbare Antriebsverbindung zwischen dem Antrieb und den Werkstückaufnahmen eines in der Behandlungskammer eingeführten Werkstückträgers vorhanden ist.

2. Anlage nach Anspruch 1, **dadurch gekennzeichnet, dass** die mindestens eine Behandlungskammer eine Beschichtungskammer ist und vorzugsweise mindestens eine Quelle zur Schichtabscheidung mittels PVD oder PECVD umfasst, die weiter vorzugsweise mindestens einen Einlass, verbunden mit einer Gasvorratseinrichtung mit einem reaktiven Gas, aufweist.

3. Anlage nach einem der Ansprüche 1 oder 2, **dadurch gekennzeichnet, dass** an der mindestens einen Behandlungskammer eine Dampfteilchen in die Umgebungsatmosphäre freisetzende Quelle vorhanden ist, wobei das freigesetzte Material mindestens eines der nachfolgenden Materialien umfasst:

   - ein Metall oder eine Legierung, bevorzugterweise mindestens aus der Gruppe Ti, W, Al, Cr, Mo,

   - Si, C

   - ein Oxid, Nitrid, Oxinitrid, Karbid, Oxikarbid, Oxikarbonitrid, Sulfid eines der erwähnten Metalle bzw. Legierungen.

4. Anlage nach Anspruch 3, **dadurch gekennzeichnet, dass** die Behandlungskammer mindestens eine der folgenden Quellen umfasst:

   - eine thermische Verdampfungsquelle,

- eine kathodische Bogenverdampfungsquelle,

- eine Sputterquelle, vorzugsweise eine Magentronquelle,

- eine Plasmaquelle für PECVD.

**5.** Anlage nach einem der Ansprüche 1 bis 4, **dadurch gekennzeichnet, dass** mindestens eine Behandlungskammer eine Kammer für PVD-Behandlung und/oder für PECVD ist.

**6.** Anlage nach einem der Ansprüche 1 bis 5, **dadurch gekennzeichnet, dass** die andere der mindestens zwei Behandlungskammern eine Heizkammer ist.

**7.** Anlage nach einem der Ansprüche 1 bis 6, **dadurch gekennzeichnet, dass** die andere der mindestens zwei Behandlungskammern eine Ätzkammer ist.

**8.** Anlage nach einem der Ansprüche 1 bis 7, **dadurch gekennzeichnet, dass** die andere der mindestens zwei Behandlungskammern eine Ätz- und Heizkammer ist, und dass mit ihr eine Zeitsteuereinheit wirkverbunden ist, welche die Abfolge des Heiz - und Ätzbetriebes steuert.

**9.** Anlage nach einem der Ansprüche 1 bis 8, woran mindestens eine Behandlungskammer für unterschiedliche Werkstückbehandlungen ausgelegt ist, die mit einer Zeitsteuereinheit wirkverbunden ist, welche die Zeitabfolge der unterschiedlichem Behandlungen an der erwähnten Behandlungskammer steuert.

**10.** Anlage nach einem der Ansprüche 1 bis 9, **dadurch gekennzeichnet, dass** eine Zeitsteuereinheit vorhanden ist, welche mindestens mit einem Antrieb für die Transportanordnung und/oder der Antriebsverbindung und dem Antrieb an der mindestens einen Behandlungskammer wirkverbunden ist, die die zeitliche Abfolge von Transportzyklen und Behandlungszyklen steuert.

**11.** Anlage nach Anspruch 10, **dadurch gekennzeichnet, dass** die Zeitsteuereinheit die Anlage so steuert, dass die Werkstücke im wesentlichen gleich lang in den Kammern verweilen.

**12.** Anlage nach einem der Ansprüche 1 bis 11, **dadurch gekennzeichnet, dass** an der Transportanordnung eine mit den öffnungen dichtend wirkverbirdbare Dichtanordnung vorhanden ist, gegebenenfalls unabhängig von der Transportanordnungs-Bewegung ansteuerbar.

**13.** Anlage nach einem der Ansprüche 1 bis 12, **dadurch gekennzeichnet, dass** die Antriebsverbindung zu den Werkstückaufnahmen eine Antriebsverbindung zwischen Antrieb und Werkstückträger umfasst.

**14.** Anlage nach Anspruch 13, **dadurch gekennzeichnet, dass** die Antriebsverbindung zusätzlich auf beweglich am Werkstückträger gelagerte Werkstückaufnahmen wirkt.

**15.** Anlage nach einem der Ansprüche 1 bis 14, **dadurch gekennzeichnet, dass** die Transportanordnung in der Verteilkammer um eine Zentralachse drehbeweglich ist und mindestens eine radial bezüglich der Zentralachse bewegliche Aufnahmeanordnung für jeweils einen Werkstückträger aufweist.

**16.** Anlage nach einem der Ansprüche 1 bis 15, **dadurch gekennzeichnet, dass** eine, vorzugsweise frei programmierbare, Zeitsteuereinheit vorhanden ist, welche mindestens mit dem Transportanordnungs-Antrieb und dem Antrieb an der mindestens einen Behandlungskammer sowie mit Schleusenventil-Antrieben wirkverbunden ist.

**17.** Anlage nach einem der Ansprüche 1 bis 16, **dadurch gekennzeichnet, dass** eine Dichtungsanordnung für die Öffnungen, je mit den Werkstückträgern verbunden, damit eine Einheit bildet.

**18.** Anlage nach einem der Ansprüche 1 bis 17, **dadurch gekennzeichnet, dass** an mindestens einer der Behandlungskammern (53, 55, 59, 65, 67) ein Behandlungskammer-Kegelstumpfrad (207) vorhanden ist, welches in das Kammerinnere hineineinragt, dass die Werkstückträger (1, 20, 47, 205) ein vorragendes Werkstückträger-Kegelstumpfrad (211) aufweisen, wobei die Stirnflächen - vorzugsweise dabei mindestens eine der kleineren Stirnflächen - einerseits des Behandlungskammer-Kegelstumpfrades und eines Werkstückträger-Kegelstumpfrades aufeinander anliegen, wenn der Werkstückträger in der Behandlungskammer in Bearbeitungsposition ist.

**19.** Anlage nach Anspruch 18, **dadurch gekennzeichnet, dass** eines der Kegelstumpfräder am Werkstückträger und/ oder behandlungskammerseitig (207) axial federnd (209) gelagert ist.

**20.** Anlage nach einem der Ansprüche 18 oder 19, **dadurch gekennzeichnet, dass** das werkstückträgerseitige Kegelstumpfrad (211) drehantriebsgekoppelt ist mit Werkstückaufnahmen am Werkstückträger, und dass ein motorischer Drehantrieb (213, 213') kammerseitig, in Behandlungsposition des Werkstückträgers (205), mit dem werkstückträgerseitigen Kegelstumpfrad (211) gekoppelt ist.

**21.** Anlage nach einem der Ansprüche 18 bis 20, **dadurch gekennzeichnet, dass** ein kammerseitiger Drehantrieb (213) auf das werkstückträgereeitige Kegelstumpfrad (211) über das kammerseitige Kegelstumpfrad (207) oder über einen unabhängig vom kammerseitigen Kegelstumpfrad wirkenden Antrieb (213') erfolgt.

**22.** Anlage nach einem der Ansprüche 18 bis 21, **dadurch gekennzeichnet, dass** sowohl das kammerseitige Kegelstumpfrad (207) wie auch das werkstückträgerseitige (211) mindestens an den kleinen Kegelstumpfstirnflächen elektrisch leitend sind und die elektrisch leitende Fläche des werkstückträgerseitigen Kegelstumpfrades (211) elektrisch leitend ($5'_{el}$) mit Werkstückaufnahmen verbunden ist, die elektrisch leitende, kleine Stirnfläche des kammerseitigen Kegelstumpfrades (207) mit einer vorzugsweise einstellbaren elektrischen Quelle.

**23.** Anlage nach einem der Ansprüche 1 bis 22, **dadurch gekennzeichnet, dass** die Transportanordnung (43) in der Verteilkammer (40) für jeweils einzelne Werkstückträger (1, 20, 47, 205) je einen Scherenmechanismus (45') aufweisen mit einem Paar Hebelanordnungen ($232_1$, $232_2$), welche so relativ zueinander zentral schwenkgelagert sind (236), dass die Hebelarme vom Schwenklager (236) zu den jeweiligen Hebelendlagern gleich lang sind.

**24.** Anlage nach Anspruch 23, **dadurch gekennzeichnet, dass** mindestens eines der endständigen Hebelschwenklager (234, 240) des Scherenmechanismusses (45') linear verschieblich an einer Zentralanordnung ($43_Z$) der Transportanordnung gelagert ist, und dass der Scherenmechanikantrieb einen Linearantrieb (230) für das mindestens eine linear beweglich gelagerte Endlager (234, 240) umfasst oder einen Schwenkantrieb, vorzugsweise einen Antrieb, der über eine Nockenscheibe (252) und Hebel (254) auf einen der Scherenmechanismushebel ($232_1$, $232_2$) wirkt.

**25.** Anlage nach einem der Ansprüche 1 bis 24, **dadurch gekennzeichnet, dass** ein Werkstückträger (1, 20, 47, 205) vorhanden ist mit einer zu einer Einheit damit verbundenen Dichtplatte (49) für die Kammern verbindende Öffnungen, dass weiter an mindestens einer der Öffnungen eine unabhängig von der Transportanordnung betätigbare Spannvorrichtung (276, 278) vorgesehen ist, die auf eine an die Öffnung gelegte Dichtplatte (49) eingreift.

**26.** Anlage nach Anspruch 25, **dadurch gekennzeichnet, dass** die Spannanordnung eine motorisch verschiebliche Rollenanordnung (276), kammerseitig oder dichtplattenseitig, umfasst sowie eine Kurvenplatte (278), dichtplattenseitig oder kammerseitig, und dass die Rollenanordnung (276) mit der Kurvenbahn (280) der Kurvenplatte (278) zur Erstellung oder zum Lösen der Dichtungspressung zwischen Dichtplatte (49) und Öffnungsberandung in Wirkverbindung steht.

**27.** Elektrische und/oder mechanische Kopplungsanordnung zwischen einer Vakuumbehandlungskammer und einem Werkstückträger mit in der Kammer zu behandelnden Werkstücken, **dadurch gekennzeichnet, dass** sie ein kammerseitiges Kegelstumpfrad (207) und ein werkstückträgerseitiges Kegelstumpfrad (211) umfasst, deren kleine Stirnflächen in Behandlungsposition des Werkstückträgers in der Kammer aufeinander anliegen und eine mechanische Antriebsverbindung und/oder eine elektrische Übertragungsverbindung von Kammer auf Werkstückträger erstellen.

**28.** System, umfassend eine Anlage nach Anspruch 2, **dadurch gekennzeichnet, dass** die Gasvorratseinrichtung mindestens eines der folgenden Gase enthält:

- Stickstoff

- Wasserstoff

- ein kohlenstoffhaltiges Gas

- ein siliziumhaltiges Gas.

**29.** Verfahren zur Herstellung von Werkstücken mittels mindestens einer Vakuumbehandlung bei welcher die zu behandelnden Werkstücke über eine Bedienungskammer einer zentralen evakuierbaren Verteilkammer mit einer im wesentlichen entlang einer Ebene gesteuert getriebenen Werkstücktransportanordnung zugeführt werden, die Werkstücke aus der Verteilkammer durch eine Bedienungsöffnung, mittels der Transportanordnung, einer Behandlungskammer zugeführt wird, **dadurch gekennzeichnet, dass** eine Vielzahl von Werkstücken in der Verteilkammer einem Werkstückträger zugeführt werden, welche mit den Werkstücken mittels der Transportanordnung durch die Bedienungsöffnung der Behandlungskammer zugeführt wird, worin automatisch gesteuert ein Antrieb mit dem Werkstückträger erstellt wird und die Werkstücke während der Behandlung in der Behandlungskammer bewegt werden.

**30.** Verfahren nach Anspruch 29, **dadurch gekennzeichnet, dass** die Werkstücke in der Behandlungskammer beschichtet werden, vorzugsweise mittels eines PVD- oder eines PECVD-Verfahrens, dabei weiter bevorzugterweise unter Einlass eines Reaktivgases.

**31.** Verfahren nach Anspruch 29, **dadurch gekennzeichnet, dass** die Werkstücke in der Behandlungskammer beschichtet werden, unter Freisetzung mindestens eines der nachfolgenden Materialien:

- eines Metalls oder einer Legierung, bevorzugterweise mindestens aus der Gruppe Ti, W, Al, Cr, Mo

- Si, C

- eines Oxids, Nitrids, Oxinitrids, Karbids, Oxicarbids, Oxikarbonitrids, Sulfids eines der erwähnten Metalle bzw. Legierungen.

**32.** Verfahren nach Anspruch 29, **dadurch gekennzeichnet, dass** in der Behandlungskammer die Werkstücke durch thermisches Verdampfen, kathodisches Bogenverdampfen oder Sputtern, dabei bevorzugterweise durch Magnetronsputtern beschichtet werden.

**33.** Verfahren nach einem der Ansprüche 29 bis 32, **dadurch gekennzeichnet, dass** der Werkstückträger mit den Werkstücken durch eine weitere Bedienungsöffnung mittels der Transportanordnung einer Heizkammer zugeführt wird, worin die Werkstücke beheizt werden.

**34.** Verfahren nach einem der Ansprüche 29 bis 33, **dadurch gekennzeichnet, dass** die Werkstücke mit dem Werkstückträger und mittels der Transportanordnung in eine Ätzkammer eingebracht und dort geätzt werden.

**35.** Verfahren nach einem der Ansprüche 29 bis 34, **dadurch gekennzeichnet, dass** die Werkstücke am Werkstückträger sequentiell in mehr als eine Behandlungskammer eingebracht werden, und die Behandlungszyklen in den Behandlungskammern im wesentlichen gleich lang sind.

**36.** Verfahren nach einem der Ansprüche 29 bis 35, **dadurch gekennzeichnet, dass** die Bedienungsöffnung bei eingeführtem Werkstückträger dichtend verschlossen wird.

**37.** Verfahren nach Anspruch 36, **dadurch gekennzeichnet, dass** die Bedienungsöffnung durch den in die Behandlungskammer eingeführten Werkstückträger dichtend verschlossen wird.

**38.** Verfahren nach einem der Ansprüche 29 bis 37, **dadurch gekennzeichnet, dass** in der Behandlungskammer der Werkstückträger durch die automatisch gesteuert erstellbare Antriebsverbindung bewegt wird.

**39.** Verfahren nach Anspruch 38, **dadurch gekennzeichnet, dass** durch die Antriebsverbindung zusätzlich die Werkstücke bezüglich des Werkstückträgers bewegt werden.

**40.** Verfahren nach einem der Ansprüche 29 bis 39, **dadurch gekennzeichnet, dass** mit dem Erstellen der Antriebsverbindung die Werkstücke auf ein vorgegebenes elektrisches Potential gelegt werden.

**41.** Verfahren nach einem der Ansprüche 29 bis 40, **dadurch gekennzeichnet, dass** die Bedienungsöffnung, bei in die Behandlungskammer eingeführtem Werkstückträger, mittels einer Dichtplatte verschlossen wird, welche gegen die Berandung der Bedienungsöffnung motorisch gespannt wird.

**42.** Verfahren nach einem der Ansprüche 29 bis 41, **dadurch gekennzeichnet, dass** während der Behandlung in die Behandlungskammer mindestens eines der folgenden Gase eingelassen wird:

- Stickstoff

- Wasserstoff

- ein kohlenstoffhaltiges Gas

- ein siliziumhaltiges Gas.

**43.** Verfahren nach einem der Ansprüche 29 bis 42, **dadurch gekennzeichnet, dass** die Werkstücke in der Behandlungskammer dreidimensional behandelt werden.

**44.** Verfahren nach einem der Ansprüche 29 bis 43 zur Herstellung von Werkstücken unter Beschichtung mit einem Verschleissschutz-Schichtsystem.

**Claims**

**1.** Vacuum coating installation having at least:

- a central distribution chamber which can be evacuated with a workpiece transport arrangement driven controllably essentially along a plane;
- at least one handling chamber for the distribution chamber and at least two treatment chambers for the good to be processed, which at least three chambers communicate via handling openings with the distribution chamber, through which openings workpieces can be transported from one chamber into the other by means of the transport arrangement, **characterised in that**
- workpiece carriers are provided, each with a multitude of workpiece holders, whereby the transport arrangement transports workpiece carriers and the workpieces can be transported through the openings on the workpiece carriers,
- on at least one of the treatment chambers is provided a drive and a driving connection, which can be set and released under automatic control, between the drive and the workpiece holders of a workplace carrier introduced in the treatment chamber.

**2.** Installation according to claim 1, **characterised in that** the at least one treatment chamber is a coating chamber and preferably has at least one source for coating deposition by means of PVD or PECVD and further preferably has at least one inlet connected with a gas storage device with a reactive gas.

**3.** Installation according to claim 1 or 2, **characterised in that** on the at least one treatment chamber is a source releasing vapour particles into the surrounding atmosphere, whereby the released material comprises at least one of the following materials:

- a metal or an alloy, preferably of at least one of the group Ti, W, Al, Cr, Mo,
- Si,C,
- an oxide, nitride, oxinitride, carbide, oxicarbide, oxicarbonitride, sulphide of one of the said metals or alloys.

**4.** Installation according to claim 3, **characterised in that** the treatment chamber comprises at least one of the following sources:

- a thermal evaporation source
- a cathodic arc evaporation source,
- a sputtering source, preferably a magnetron source,
- a plasma source for PECVD.

**5.** Installation according to any of claims 1 to 4, **characterised in that** at least one treatment chamber is a chamber for PVD processing and/or for PECVD.

6.  Installation according to any of claims 1 to 5, **characterised in that** the other of the at least two treatment chambers is a heating chamber.

7.  Installation according to any of claims 1 to 6, **characterised in that** the other of the at least two treatment chambers is an etching chamber.

8.  Installation according to any of claims 1 to 7, **characterised in that** the other of the at least two treatment chambers is an etching and heating chamber, and that a time control unit is operatively connected thereto controlling the sequence of the heating and etching operation.

9.  Installation according to any of claims 1 to 8, whereat at least one treatment chamber is designed for different workpiece treatments and is operatively connected to a time control unit which controls the time sequence of the different treatments at the said treatment chamber.

10. Installation according to any of claims 1 to 9, **characterised in that** a time control unit is present which is operatively connected at least with a drive for the transport arrangement and/or the driving connection and the drive on the at least one treatment chamber and which controls the time sequence of transport cycles and treatment cycles.

11. Installation according to claim 10, **characterised in that** the time control unit controls the installation so that the workpieces remain in the chambers for essentially the same length of time.

12. Installation according to any of claims 1 to 11, **characterised in that** on the transport arrangement is provided a sealing arrangement which is sealingly operatively connectable with the openings and where applicable can be controlled independently of the movement of the transport arrangement .

13. Installation according to any of claims 1 to 12, **characterised in that** the driving connection for the workpiece holder comprises a driving connection between the drive and the workpiece carrier.

14. Installation according to claim 13, **characterised in that** the driving connection also acts on workpiece holders mounted mobile on the workpiece carrier.

15. Installation according to any of claims 1 to 14, **characterised in that** the transport arrangement is rotatably movable about a central axis in the distribution chamber and has at least one support arrangement radially movable with respect to the central axis for one workpiece carrier respectively.

16. Installation according to any of claims 1 to 15, **characterised in that** a time unit, preferably freely programmable, is present which is operatively connected at least with the transport arrangement drive and the drive on the at least one treatment chamber and with lock valve drives.

17. Installation according to any of claims 1 to 16, **characterised in that** a seal arrangement for the openings, each connected with the workpiece carriers, forms a unit with these.

18. Installation according to any of claims 1 to 17, **characterised in that** on at least one of the treatment chambers (53, 55, 59, 65, 67) is provided a treatment chamber frustoconical wheel (207) which projects into the chamber interior, that the workpiece carriers (1, 20, 47, 205) have a projecting workpiece carrier frustoconical wheel (211), whereby the faces - preferably at least one of the smaller faces - on one hand of the treatment chamber frustoconical wheel and on the other hand of a workpiece carrier frustoconical wheel lie on each other when the workpiece carrier is in the processing position in the treatment chamber.

19. Installation according to claim 18, **characterised in that** one of the frustoconical wheels on the workpiece carrier and/or on the treatment chamber side (207) is mounted axially sprung (209).

20. Installation according to one of claims 18 or 19, **characterised in that** the frustoconical wheel (211) on the workpiece carrier side is rotational drive-coupled with workpiece holders on the workpiece carrier, and that a motoric rotary drive (213, 213') on the chamber side is coupled with the frustoconical wheel (211) on the workpiece carrier side when the workpiece carrier (205) is in the processing position.

21. Installation according to any of claims 18 to 20, **characterised in that** a chamber-side rotary drive (213) acts on the frustoconical wheel (211) on the workpiece carrier side via the frustoconical wheel (207) on the chamber side or via a drive (213') acting independently of the frustoconical wheel on the chamber side.

22. Installation according to any of claims 18 to 21, **characterised in that** both the frustoconical wheel (207) on the chamber side and that (211) on the workpiece carrier side are electrically conductive at least on the small frustoconical wheel surfaces, and the electrically conductive surface of the frustoconical wheel (211) on the workpiece carrier side is connected electrically conductively ($5'_{el}$) with workpiece holders, the electrically conductive small face of the frustoconical wheel (207)on the chamber side is electrically connected with a preferably adjustable electrical source.

23. Installation according to any of claims 1 to 22, **characterised in that** the transport arrangement (43) in the distribution chamber (4) has a shears mechanism (45') respectively for an individual workpiece carrier (1, 20, 47, 205) with a pair of lever arrangements ($232_1$, $232_2$) which are centrally pivotably mounted (236) relative to each other so that the lever arms from the pivot bearing (236) to the respective lever end bearings are equally long.

24. Installation according to claim 23, **characterised in that** at least one end-mounted lever pivot bearings (234, 240) of the shears mechanism (45') is linearly displaceably mounted on a central arrangement ($43_2$) of the transport arrangement and that the shears mechanism drive comprises a linear drive (230) for the at least one linearly displaceably mounted end bearing (234, 240) or a pivot drive, preferably a drive, which acts via a cam disc (252) and lever (254) on one of the shear mechanism levers ($232_1$, $232_2$).

25. Installation according to any of claims 1 to 24, **characterised in that** a workpiece carrier (1, 20, 47, 205) is provided with a sealing plate (49), connected therewith as one unit, for the openings connecting the chambers, that also on at least one of the openings is provided a tensioning device (276, 278) which can be operated independently of the transport arrangement and which acts on a sealing plate (49) placed on the opening.

26. Installation according to claim 25, **characterised in that** the tensioning device comprises a motorised displaceable roller arrangement (276) on the chamber side or on the sealing plate side, and a cam plate (278) on the sealing plate side or the chamber side, and that the roller arrangement (276) is operatively connected with the curve path (280) of the cam plate (278) to set or release the sealing pressure between the sealing plate (49) and the opening edge.

27. Electric and/or mechanical coupling arrangement between a vacuum treatment chamber and a workpiece carrier with workpieces to be processed in the chamber, **characterised in that** it comprises a frustoconical wheel (207) on the chamber side and a frustoconical wheel (211) on the workpiece carrier side, the small faces of which lie on each other when the workpiece carrier is in the processing position in the chamber and create a mechanical driving connection and/or an electric transmission connection from the chamber to the workpiece carrier.

28. System comprising an installation according to claim 2, **characterised in that** the gas storage device contains at least one of the following gases:

   - nitrogen
   - hydrogen
   - a carbon-containing gas.
   - a silicon-containing gas.

29. A method for manufacturing workpieces by means of at least one vacuum processing in which the workpieces to be processed are conveyed via a handling chamber to a central distribution chamber which can be evacuated by means of a workpiece transport arrangement driven controllably essentially along a plane, the workpieces are supplied from the distribution chamber through a handling opening by means of the transport arrangement to a treatment chamber, **characterised in that** a multitude of workpieces in the distribution chamber is supplied to a workpiece carrier which, with the workpieces, is passed by means of the transport arrangement through the handling opening to the treatment chamber, in which automatically controlled a drive is installed to the workpiece carrier and the workpieces are moved in the treatment chamber during the treatment.

30. Method according to claim 29, **characterised in that** the workpieces are coated in the treatment chamber, preferably by means of a PVD or PECVD process, thereby preferably under the introduction of a reactive gas.

**31.** Method according to claim 29, **characterised in that** the workpieces are coated in the treatment chamber under the release of at least one of the following materials:

- a metal or an alloy, preferably of at least one of the group Ti, W, Al, Cr, Mo,
- Si, C,
- an oxide, nitride, oxinitride, carbide, oxicarbide, oxicarbonitride, sulphide of one of the said metals or alloys.

**32.** Method according to claim 29, **characterised in that** the workpieces in the treatment chamber are coated by thermal evaporation, cathodic arc evaporation or sputtering, preferably by magnetron sputtering.

**33.** Method according to any of claims 29 to 32, **characterised in that** the workpiece carrier with the workpieces is passed by means of the transport arrangement through a further handling opening to a heating chamber in which the workpieces are heated.

**34.** Method according to any of claims 29 to 33, **characterised in that** the workpieces with the workpiece carrier are introduced by means of the transport arrangement into an etching chamber in which the workpieces are etched.

**35.** Method according to any of claims 29 to 34, **characterised in that** the workpieces on the workpiece carrier are introduced sequentially into more than one treatment chamber, and the treatment cycles in the treatment chambers are essentially of equal duration.

**36.** Method according to any of claims 29 to 35, **characterised in that** the handling openings are closed sealingly when the workpiece carrier is introduced.

**37.** Method according to claim 36, **characterised in that** the handling opening is closed tightly by the introduced workpiece carrier.

**38.** Method according to any of claims 29 to 37, **characterised in that** in the treatment chamber the workpiece carrier is moved by the driving connection which can be established under automatic control.

**39.** Method according to claim 38, **characterised in that** the workpieces are also moved relative to the workpiece carrier by the driving connection.

**40.** Method according to any of claims 29 to 39, **characterised in that** on establishment of the driving connection, the workpieces are laid to a prespecified electrical potential.

**41.** Method according to any of claims 29 to 40, **characterised in that** the handling opening, when the workpiece carrier is introduced into the treatment chamber, is sealed by means of a sealing plate which is clamped, motorised, against the edge of the operating opening.

**42.** Method according to any of claims 29 to 41, **characterised in that** during the treatment in the treatment chamber at least one of the following gases is introduced:

- nitrogen
- hydrogen
- a carbon-containing gas
- a silicon-containing gas.

**43.** Method according to any of claims 29 to 42, **characterised in that** the workpieces are treated three-dimensionally in the treatment chamber.

**44.** Method according to any of claims 29 to 43 for manufacturing of workpieces by coating with a wear-protection coating system.

**Revendications**

**1.** Installation d'application de revêtement sous vide comprenant au moins :

- une chambre de distribution centrale apte à être mise sous vide et comportant un dispositif de transport de pièces entraîné de manière commandée sensiblement le long d'un plan ; et
- au moins une chambre de desserte pour la chambre de distribution et au moins deux chambres de traitement pour le produit à traiter, ces trois chambres, ou plus, communiquant avec la chambre de distribution grâce à des ouvertures de desserte par lesquelles des pièces peuvent être amenées d'une chambre à l'autre à l'aide du dispositif de transport,

**caractérisée**

- **en ce qu'**il est prévu des porte-pièces comportant chacun plusieurs logements pour pièce, le dispositif de transport transportant lesdits porte-pièces, et les pièces pouvant être transportées sur les porte-pièces à travers les ouvertures, et
- **en ce qu'**il est prévu sur l'une au moins des chambres de traitement un entraînement et une liaison d'entraînement, apte à être réalisée et supprimée grâce à une commande automatique, entre ledit entraînement et les logements pour pièce d'un porte-pièces introduit dans la chambre de traitement.

2. Installation selon la revendication 1, **caractérisée en ce que** la ou les chambres de traitement sont constituées par une chambre d'application de revêtement et comprennent de préférence au moins une source pour le dépôt de couche par dépôt physique en phase vapeur (PVD) ou dépôt chimique en phase vapeur avec utilisation d'un plasma (PECVD) qui comporte également, de préférence, au moins une admission reliée à un dispositif formant réservoir de gaz avec un gaz réactif.

3. Installation selon la revendication 1 ou 2, **caractérisée en ce qu'**il est prévu dans la ou les chambres de traitement une source qui libère des particules de vapeur dans l'atmosphère environnante, la matière libérée contenant l'une au moins des matières suivantes :

- un métal ou un alliage, de préférence au moins du groupe Ti, W, Al, Cr, Mo,
- Si, C,
- un oxyde, un nitrure, un oxynitrure, un carbure, un oxycarbure, un oxycarbonitrure, un sulfure de l'un des métaux ou alliages mentionnés.

4. Installation selon la revendication 3, **caractérisée en ce que** la chambre de traitement comprend au moins l'une des sources suivantes :

- une source d'évaporation thermique,
- une source d'évaporation cathodique par arc,
- une source de pulvérisation cathodique, de préférence une source de magnétron,
- une source de plasma pour le dépôt chimique en phase vapeur avec utilisation d'un plasma (PECVD).

5. Installation selon l'une des revendications 1 à 4, **caractérisée en ce qu'**au moins une chambre de traitement est une chambre pour le traitement par dépôt physique en phase vapeur (PVD) et/ou pour le dépôt chimique en phase vapeur avec utilisation d'un plasma (PECVD).

6. Installation selon l'une des revendications 1 à 5, **caractérisée en ce que** l'autre chambre de traitement est une chambre de chauffe.

7. Installation selon l'une des revendications 1 à 6, **caractérisée en ce que** l'autre chambre de traitement est une chambre d'attaque chimique.

8. Installation selon l'une des revendications 1 à 7, **caractérisée en ce que** l'autre chambre de traitement est une chambre d'attaque chimique et de chauffe, et **en ce qu'**il est prévu, en relation fonctionnelle avec elle, une unité de synchronisation qui commande la succession de la chauffe et de l'attaque chimique.

9. Installation selon l'une des revendications 1 à 8, dans laquelle au moins une chambre de traitement est conçue pour des traitements de pièces différents, cette chambre de traitement étant en relation fonctionnelle avec une unité de synchronisation qui commande la succession dans le temps des différents traitements effectués dans ladite chambre de traitement.

10. Installation selon l'une des revendications 1 à 9, **caractérisée en ce qu'**il est prévu une unité de synchronisation qui est en relation fonctionnelle au moins avec un entraînement pour le dispositif de transport et/ou la liaison d'entraînement et l'entraînement prévu sur la ou les chambres de traitement et qui commande la succession dans le temps de cycles de transport et de cycles de traitement.

11. Installation selon la revendication 10, **caractérisé en ce que** l'unité de synchronisation commande l'installation de telle sorte que les pièces restent pendant une durée sensiblement égale dans les chambres.

12. Installation selon l'une des revendications 1 à 11, **caractérisée en ce qu'**il est prévu sur le dispositif de transport un dispositif d'étanchéité qui est apte à être mis en relation fonctionnelle d'étanchéité avec les ouvertures et qui est éventuellement apte à être commandé indépendamment du mouvement du dispositif de transport.

13. Installation selon l'une des revendications 1 à 12, **caractérisée en ce que** la liaison d'entraînement avec les logements pour pièce comprend une liaison d'entraînement entre l'entraînement et le porte-pièces.

14. Installation selon la revendication 13, **caractérisée en ce que** la liaison d'entraînement agit en supplément sur des logements pour pièce montés mobiles sur le porte-pièces.

15. Installation selon l'une des revendications 1 à 14, **caractérisée en ce que** le dispositif de transport est mobile en rotation autour d'un axe central, dans la chambre de distribution, et comporte au moins, pour chaque porte-pièces, un dispositif de réception mobile radialement par rapport à l'axe central.

16. Installation selon l'une des revendications 1 à 15, **caractérisée en ce qu'**il est prévu une unité de synchronisation de préférence librement programmable qui est en relation fonctionnelle au moins avec l'entraînement de dispositif de transport, avec l'entraînement prévu sur la ou les chambres de traitement et avec des entraînements de vanne formant sas.

17. Installation selon l'une des revendications 1 à 16, **caractérisée en ce qu'**un dispositif d'étanchéité pour les ouvertures, relié aux porte-pièces respectifs, forme avec ceux-ci une unité.

18. Installation selon l'une des revendications 1 à 17, **caractérisée en ce qu'**il est prévu sur l'une au moins des chambres de traitement (53, 55, 59, 65, 67) un pignon tronconique de chambre de traitement (207) qui pénètre dans la chambre, et **en ce que** les porte-pièces (1, 20, 47, 205) comportent un pignon tronconique de porte-pièces saillant (211), étant précisé que les surfaces frontales - de préférence l'une au moins des petites surfaces frontales - du pignon tronconique de chambre de traitement, d'un côté, et d'un pignon tronconique de porte-pièces, de l'autre côté, sont appliquées l'une sur l'autre lorsque le porte-pièces est en position de traitement dans la chambre de traitement.

19. Installation selon la revendication 18, **caractérisée en ce que** l'un des pignons tronconiques est monté pour faire ressort axialement (209) sur le porte-pièces et/ou côté chambre de traitement (207).

20. Installation selon la revendication 18 ou 19, **caractérisé en ce que** l'entraînement en rotation du pignon tronconique (211) prévu côté porte-pièces est accouplé à celui des logements pour pièce prévus sur le porte-pièces, et **en ce qu'**un entraînement en rotation à moteur (213, 213') est accouplé, côté chambre, dans la position de traitement du porte-pièces (205), au pignon tronconique (211) prévu côté porte-pièces.

21. Installation selon l'une des revendications 18 à 20, **caractérisée en ce qu'**un entraînement en rotation (213) prévu côté chambre fait tourner le pignon tronconique (211) prévu côté porte-pièces par l'intermédiaire du pignon tronconique (207) prévu côté chambre ou d'un entraînement (213') qui agit indépendamment du pignon tronconique situé côté chambre.

22. Installation selon l'une des revendications 18 à 21, **caractérisée en ce que** le pignon tronconique (207) situé côté chambre et le pignon tronconique (211) situé côté porte-pièces sont tous les deux conducteurs d'électricité au moins sur leur petite surface frontale, et la surface conductrice d'électricité du pignon tronconique (211) prévu côté porte-pièces est reliée de manière électriquement conductrice ($S'_{el}$) aux logements pour pièces tandis que la petite surface frontale conductrice d'électricité du pignon tronconique (207) prévu côté chambre est reliée de manière électriquement conductrice à une source électrique de préférence réglable.

**23.** Installation selon l'une des revendications 1 à 22, **caractérisée en ce que** le dispositif de transport (43) prévu dans la chambre de distribution (40) comporte pour chaque porte-pièces individuel (1, 20, 47, 205) un mécanisme articulé (45') avec deux dispositifs de levier ($232_1$, $232_2$) qui sont montés (236) pour pouvoir pivoter de manière centrale l'un par rapport à l'autre de telle sorte que les bras de levier présentent des longueurs égales entre le pivot (236) et les paliers d'extrémité de levier.

**24.** Installation selon la revendication 23, **caractérisé en ce que** l'un au moins des paliers de pivotement de levier (234, 240) du mécanisme articulé (45') situés aux extrémités est monté pour être mobile en translation sur un dispositif central ($43_Z$) du dispositif de transport, et **en ce que** l'entraînement du mécanisme articulé comprend un entraînement linéaire (230) pour le ou les paliers d'extrémité (234, 240) montés mobiles linéairement ou un entraînement pivotant, de préférence un entraînement qui agit sur l'un des leviers de mécanisme articulé ($232_1$, $232_2$) par l'intermédiaire d'un disque à came (252) et de leviers (254).

**25.** Installation selon l'une des revendications 1 à 24, **caractérisée en ce qu'**il est prévu un porte-pièces (1, 20, 47, 205) auquel une plaque d'étanchéité (49) pour des ouvertures reliant les chambres est reliée pour former une unité, et **en ce qu'**il est également prévu sur l'une au moins des ouvertures un dispositif de serrage (276, 278) qui est apte à être actionné indépendamment du dispositif de transport et qui agit sur une plaque d'étanchéité (49) appliquée contre l'ouverture.

**26.** Installation selon la revendication 25, **caractérisée en ce que** le dispositif de serrage comprend un dispositif à rouleau (276) mobile à l'aide d'un moteur, côté chambre ou côté plaque d'étanchéité, ainsi qu'une plaque courbe (278), côté plaque d'étanchéité ou côté chambre, et **en ce que** le dispositif à rouleau (276) est en relation fonctionnelle avec la face courbe (280) de la plaque courbe (278) pour réaliser ou supprimer la compression d'étanchéité entre la plaque d'étanchéité (49) et le bord de l'ouverture.

**27.** Dispositif d'accouplement électrique et/ou mécanique entre une chambre de traitement sous vide et un porte-pièces portant des pièces à traiter dans la chambre, **caractérisé en ce qu'**il comprend un pignon tronconique (207) situé côté chambre et un pignon tronconique (211) situé côté porte-pièces dont les petites surfaces frontales sont appliquées l'une sur l'autre lorsque le porte-pièces est en position de traitement dans la chambre, et réalisent une liaison d'entraînement mécanique et/ou une liaison de transmission électrique entre la chambre et le porte-pièces.

**28.** Système comprenant une installation selon la revendication 2, **caractérisé en ce que** le dispositif formant réservoir de gaz contient l'un au moins des gaz suivants :

- azote
- hydrogène
- un gaz carboné
- un gaz contenant du silicium.

**29.** Procédé pour fabriquer des pièces à l'aide d'au moins un traitement sous vide avec lequel les pièces à traiter sont amenées par l'intermédiaire d'une chambre de desserte dans une chambre de distribution centrale apte à être mise sous vide, à l'aide d'un dispositif de transport de pièces entraîné de manière commandée sensiblement le long d'un plan, puis les pièces sortent de la chambre de distribution par une ouverture de desserte, grâce au dispositif de transport, pour être amenées dans une chambre de traitement, **caractérisé en ce que** plusieurs pièces, dans la chambre de distribution, sont amenées sur un porte-pièces qui est lui-même amené avec lesdites pièces à l'aide du dispositif de transport, par l'ouverture de desserte, dans la chambre de traitement, dans laquelle un entraînement est réalisé avec le porte-pièces de manière commandée automatiquement et les pièces sont déplacées dans la chambre de traitement pendant le traitement.

**30.** Procédé selon la revendication 29, **caractérisé en ce que** les pièces sont revêtues dans la chambre de traitement, de préférence à l'aide d'un procédé de dépôt physique en phase vapeur (PVD) ou d'un procédé de dépôt chimique en phase vapeur avec utilisation d'un plasma (PECVD), de préférence avec introduction d'un gaz réactif.

**31.** Procédé selon la revendication 29, **caractérisé en ce que** les pièces sont revêtues dans la chambre de traitement, avec le dégagement de l'une au moins des matières suivantes :

- un métal ou un alliage, de préférence au moins du groupe Ti, W, Al, Cr, Mo

- Si, C
- un oxyde, un nitrure, un oxynitrure, un carbure, un oxycarbure, un oxycarbonitrure, un sulfure de l'un des métaux ou alliages mentionnés.

32. Procédé selon la revendication 29, **caractérisé en ce que** dans la chambre de traitement, les pièces sont revêtues par évaporation thermique, évaporation cathodique par arc ou pulvérisation cathodique, de préférence par magnétron.

33. Procédé selon l'une des revendications 29 à 32, **caractérisé en ce que** le porte-pièces est amené avec les pièces par une autre ouverture de desserte, à l'aide du dispositif de transport, dans une chambre de chauffe dans laquelle les pièces sont chauffées.

34. Procédé selon l'une des revendications 29 à 33, **caractérisé en ce que** les pièces sont amenées avec le porte-pièces et à l'aide du dispositif de transport dans une chambre d'attaque chimique et sont soumises dans celle-ci à une attaque chimique.

35. Procédé selon l'une des revendications 29 à 34, **caractérisé en ce que** les pièces qui se trouvent sur le porte-pièces sont introduites séquentiellement dans plus d'une chambre de traitement et les cycles de traitement ont sensiblement la même longueur dans les chambres de traitement.

36. Procédé selon l'une des revendications 29 à 35, **caractérisé en ce que** l'ouverture de desserte est fermée de manière étanche quand le porte-pièces est introduit.

37. Procédé selon la revendication 36, **caractérisé en ce que** l'ouverture de desserte est fermée de manière étanche par le porte-pièces introduit dans la chambre de traitement.

38. Procédé selon l'une des revendications 29 à 37, **caractérisé en ce que** dans la chambre de traitement, le porte-pièces est déplacé par la liaison d'entraînement apte à être réalisée de manière commandée automatiquement.

39. Procédé selon la revendication 38, **caractérisé en ce que** grâce à la liaison d'entraînement, les pièces sont déplacées en supplément par rapport au porte-pièces.

40. Procédé selon l'une des revendications 29 à 39, **caractérisé en ce qu'**avec la réalisation de la liaison d'entraînement, les pièces sont mises à un potentiel électrique prédéfini.

41. Procédé selon l'une des revendications 29 à 40, **caractérisé en ce que** l'ouverture de desserte, quand le porte-pièces est introduit dans la chambre de traitement, est fermée à l'aide d'une plaque d'étanchéité qui est serrée à l'aide d'un moteur contre le bord de ladite ouverture de desserte.

42. Procédé selon l'une des revendications 29 à 41, **caractérisé en ce que** pendant le traitement, on fait entrer dans la chambre de traitement l'un au moins des gaz suivants :

- azote
- hydrogène
- un gaz carboné
- un gaz contenant du silicium.

43. Procédé selon l'une des revendications 29 à 42, **caractérisé en ce que** les pièces sont traitées en trois dimensions dans la chambre de traitement.

44. Procédé selon l'une des revendications 29 à 43 pour fabriquer des pièces en appliquant sur celles-ci un système stratifié anti-usure.

FIG.1

FIG.2

FIG.3

FIG.4

FIG.5

FIG.6

FIG.7

FIG.8

FIG.9

FIG.10

FIG.11

FIG.12

FIG.13

FIG.14

FIG.15

FIG. 16

FIG.17

FIG.18

FIG.19

FIG.20

FIG. 21